(19) Europäisches Patentamt

European Patent Office

Office européen des brevets

(11) **EP 3 943 976 B1**

(12) **EUROPEAN PATENT SPECIFICATION**

(45) Date of publication and mention
of the grant of the patent:
**12.02.2025 Bulletin 2025/07**

(21) Application number: **21185892.3**

(22) Date of filing: **15.07.2021**

(51) International Patent Classification (IPC):
**G01S 7/484** *(2006.01)*   **H01S 5/0239** *(2021.01)*
**G01S 17/10** *(2020.01)*

(52) Cooperative Patent Classification (CPC):
**H01S 5/0428; G01S 7/484; G01S 17/10;**
**H01S 5/02345; H01S 5/0239; H05K 1/0243;**
H01S 5/02257; H01S 5/423; H05K 2201/0792;
H05K 2201/09345; H05K 2201/10015;
H05K 2201/10121; H05K 2203/049

(54) **LIGHT SOURCE SYSTEM**

LICHTQUELLENSYSTEM

SYSTÈME DE SOURCE DE LUMIÈRE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **23.07.2020 US 202063055663 P
25.06.2021 US 202117358931**

(43) Date of publication of application:
**26.01.2022 Bulletin 2022/04**

(73) Proprietor: **Analog Devices International
Unlimited Company
Limerick (IE)**

(72) Inventors:
• **HURWITZ, Jonathan Ephraim David**
**Edinburgh, EH6 7PJ (GB)**
• **ENGLISH, Eoin**
**Limerick (IE)**

(74) Representative: **Horler, Philip John
Withers & Rogers LLP
2 London Bridge
London SE1 9RA (GB)**

(56) References cited:
**US-A1- 2017 070 029   US-A1- 2018 278 011**

## Description

## Technical Field

The present disclosure relates to a light source system, which may be used, for example, as the light source in a time-of-flight camera system.

## Background

Time-of-flight (ToF) camera systems are range imaging systems that resolve the distance between the camera and an object by measuring the round trip time of a light signal emitted from the ToF camera system. The systems typically comprise a light source (such as a laser or LED), a light source driver to control the emission of light from the light source, an image sensor to image light reflected by the subject, an image sensor driver to control the operation of the image sensor, optics to shape the light emitted from the light source and to focus light reflected by the object onto the image sensor, and a computation unit configured to determine the distance to the object by determining the amount of time between an emission of light from the light source and a corresponding reflection from the object.

ToF camera systems may measure distances ranging from a few centimetres to 100s or 1000s of metres. Given the high speed of light, a time difference of only 16.66ns between an emission of light and reception of reflected light corresponds to an object 2.5m from the camera system. Therefore, ToF camera systems require high levels of temporal precision and control in order to measure distances accurately.

US 2018/0278011 A1 discloses a laser diode module which includes a first semiconductor die including at least one electronic switch, and a second semiconductor die including at least one laser diode. The second semiconductor die is bonded on the first semiconductor die using a chip-on-chip connecting technology to provide electrical connection between the electronic switch and the laser diode.

## Summary

The present disclosure relates to light source driving systems, for example laser driving systems. The systems are configured to include a very low inductance current loop for driving an initial part of the current drive signal to turn on and turn off the light source. By implementing the system to have a very low inductance current loop, a very fast turn on time may be achieved for the light source, which can be particularly useful for Time of Flight systems that require a very quick turn-on response or modulation frequency from the light source.

The invention is defined by a light source system according to claim 1, with further embodiments set out in the dependent claims. In a first aspect of the disclosure, according to the invention there is provided a light source system comprising: a substrate; a light source mounted on a surface of the substrate, wherein the light source comprises: an upper surface having an upper terminal; and a mounting surface conductively fixed to the surface of the substrate and having a lower terminal, the light source being configured to be turned on by a current flowing between the upper terminal and the lower terminal, a vertical capacitor for supplying a first part of the current to drive the light source, wherein the vertical capacitor comprises: an upper surface comprising an upper terminal to a first plate of the vertical capacitor, wherein the upper terminal of the vertical capacitor is electrically coupled to the upper terminal of the light source; and a mounting surface conductively fixed to the surface of the substrate and comprising a lower terminal to a second plate of the vertical capacitor; and a current driver mounted on the surface of the substrate and coupled to the light source and the vertical capacitor for controlling the flow of current from the vertical capacitor to the light source in order to control operation of the light source, wherein the substrate comprises a voltage terminal that is electrically coupled to the vertical capacitor, the voltage terminal for supplying a second part of the current required to drive the light source.

The voltage terminal of the substrate may be electrically coupled to the upper terminal of the vertical capacitor by a first interconnector.

A distance between the surface of the substrate and the upper terminal of the light source is substantially the same as a distance between the surface of the substrate and the upper terminal of the vertical capacitor (eg, within 25%).

The may be light source mounted on the surface of the substrate using a conductive podium having a thickness such that the distance between the surface of the substrate and the upper terminal of the light source is substantially the same as the distance between the surface of the substrate and the upper terminal of the vertical capacitor.

The current driver may be a low-side driver and the lower terminal of the light source may be electrically coupled to the lower terminal of the vertical capacitor by the current driver, wherein the upper terminal of the vertical capacitor is electrically coupled to the upper terminal of the light source by a second interconnector, such that when the light source is on current flows from the upper terminal of the vertical capacitor to the upper terminal of the light source and then from the lower terminal of the light source back to the vertical capacitor via the current driver.

The first interconnector may comprise one or more bond wires.

The substrate may comprise a first conductive path (eg, a first conductive trace) to which the lower terminal of the light source and a first terminal of the current driver are conductively fixed, such that when the light source is on current flows through the first conductive path from the lower terminal of the light source to the first terminal of the current driver; and a second conductive path (eg, a second conductive trace) to which the lower terminal of the vertical capacitor and a second terminal of the current driver are conductively fixed, such that when the light source is on current flows through the second conductive path from the second terminal of the driver to the lower terminal of the vertical capacitor.

The second conductive path may be held at a reference potential, such as ground.

The current driver may be a high-side driver and the upper terminal of the vertical capacitor may be electrically coupled to the upper terminal of the light source by the current driver.

The substrate may comprise a reference voltage conductive path to which the lower terminal of the light source and lower terminal of the vertical capacitor are conductively fixed, such that when the light source is on current flows through a first conductive path from the lower terminal of the light source to the lower terminal of the vertical capacitor.

A part of the reference voltage conductive path may pass underneath the current driver such that when the light source is on current flows through the reference voltage conductive path from the lower terminal of the light source to the lower terminal of the vertical capacitor, underneath the current driver in substantially the opposite direction to the current flow from the upper terminal of the vertical capacitor to the upper terminal of the light source.

The high-side current driver may comprise: a first surface having a third terminal and a fourth terminal; and a second surface that is fixed to the surface of the substrate, wherein the upper terminal of the vertical capacitor is coupled to the third terminal of the current driver by a third interconnector and the fourth terminal of the current driver is coupled to the upper terminal of the light source by a fourth interconnector.

Therein the third interconnector may comprise one or more bond wires and the fourth interconnector may comprise one or more bond wires.

The upper terminal of the light source, the upper terminal of the vertical capacitor and the third and fourth terminals of the current driver may all be at substantially the same distance from the surface of the substrate.

In all aspects of the disclosure, the first interconnector may comprise a conductive platform having a mounting surface that is conductively fixed to the voltage terminal and an upper surface that is at substantially the same distance from the surface of the substrate as the upper terminal of the vertical capacitor; and at least one conductive element fixed to the upper surface of the conductive platform and the upper terminal of the vertical capacitor.

In all aspects of the disclosure, the substrate may be a non-conductive substrate of a PCB.

The light source system may further comprise a further capacitor for supplying a third part of the current to drive the light source, wherein the further capacitor has a larger capacitance than the vertical capacitor, and wherein the vertical capacitor, light source and current driver are coupled together to form a first current loop, and wherein the further capacitor, light source and current driver are coupled together to form a second current loop.

The light source system may further comprise a second vertical capacitor, wherein the second vertical capacitor comprises: an upper surface comprising an upper terminal to a first plate of the second vertical capacitor, wherein the upper terminal of the second vertical capacitor is electrically coupled to a second upper terminal of the light source, wherein the first upper terminal of the light source is positioned at a first side of the upper surface of the light source and the second upper terminal of the light source is positioned at a second, opposing side of the upper surface of the light source; and a mounting surface conductively fixed to the surface of the substrate and comprising a lower terminal to a second plate of the vertical capacitor, wherein the second vertical capacitor is electrically coupled to the voltage terminal of the substrate and is positioned on the opposite side of the light source to the position of the first vertical capacitor such that when the light source is on current flows from the first vertical capacitor to the light source in substantially the opposite direction to current that flows from the second vertical capacitor to the light source.

In a second aspect of the disclosure, not part of the appended claims, there is provided a light source system comprising: a driver IC comprising a current driver; a light source mounted on a surface of the driver IC, wherein the light source comprises: a first terminal; and a second terminal on a mounting surface of the light source, the second terminal of the light source being conductively bonded to a first terminal of the current driver on the surface of the driver IC; and a capacitor mounted on the surface of the driver IC, wherein the capacitor comprises: a first terminal to a first plate of the capacitor, the first terminal being conductively coupled to a supply voltage and to the first terminal of the light source such that when the light source is on current flows from the first plate of the capacitor to the first terminal of the light source; and a second terminal to a second plate of the capacitor, the second terminal of the capacitor being on a mounting surface of the capacitor and conductively bonded to a second terminal of the current driver on the surface of the driver IC such that when the light source is on current flows from the second terminal of the light source to the second plate of the capacitor via the current driver.

The capacitor may be a vertical silicon capacitor, wherein the first terminal of the capacitor is on an upper surface of the capacitor. The first terminal of the capacitor may be coupled to the first terminal of the light source using bond wires.

Alternatively, the capacitor may be a lateral silicon capacitor, wherein the second terminal of the capacitor is on the mounting surface of the capacitor and is conductively bonded to a driver IC conductive path that is electrically coupled to the first terminal of the light source. The first terminal of the light source may be on an upper surface of the light source and the driver IC conductive path electrically coupled to the first terminal of the light source using bond wires. Or, the first terminal of the light source may be on the mounting surface of the light source and the driver IC conductive path electrically coupled to the first terminal of the light source using conductive bonding.

In a third aspect of the disclosure not part of the appended claims, there is provided a laser driving circuit comprising: a laser; a first capacitor coupled to the laser for supplying current to drive the laser, wherein the first capacitor has a first capacitance; a second capacitor coupled to the laser for supplying current to drive the laser, wherein the second capacitor has a second capacitance that is larger than the first capacitance; a current driver coupled to the laser, the first capacitor and the second capacitor for controlling a flow of current between the laser and the first and second capacitors, wherein the laser, current driver and first capacitor together form a first current circuit, and wherein the laser, current driver and second capacitor together form a second current circuit, and wherein an inductance of the first current circuit is relatively lower than an inductance of the second current circuit.

The first capacitor may be a vertical silicon capacitor having a lower surface conductively bonded to a conductive trace on a surface of a substrate.

The laser may be mounted on the surface of the substrate, wherein an upper terminal on an upper surface of the first capacitor is electrically coupled to an upper terminal on an upper surface of the laser such that drive current flows from the upper terminal of the first capacitor to the upper terminal of the laser when the laser is turned on.

The first capacitor may be coupled to the current driver by mounting the first capacitor on a surface of an integrated circuit in which the current driver formed and conductively bonding a terminal of the first capacitor to a first terminal on the surface of the integrated circuit. The laser may be coupled to the current driver by mounting the laser on the surface of the integrated circuit and conductively bonding a terminal of the laser to a second terminal on the surface of the integrated circuit.

## Drawings

Aspects of the disclosure are described with reference to the following drawings, in which:

Figures 1A and 1B show example representations of a packaged light source module;
Figure 1C shows the packaged light source module of Figures 1A and 1B mounted on a PCB;
Figure 1D shows a circuit diagram representing the light source module of Figures 1A and 1B;

Figure 1E shows a representation of an ideal drive current signal and an ideal optical power signal for a light source;
Figure 2A shows a light source system in accordance with an aspect of the present disclosure;
Figure 2B shows a circuit diagram representation of the configuration of the system of Figure 2A;
Figure 3A shows a side on representation of the first capacitor and the light source of the system of Figure 2A;
Figure 3B shows a further side on representation of the first capacitor and the light source of the system of Figure 2A with a podium used to raise the height of the light source;
Figure 3C shows an even further side on representation of the first capacitor and the light source of the system of Figure 2A with an additional podium to raise the height of the voltage terminal;
Figure 3D shows an even further side on representation of the first capacitor and the light source of the system of Figure 2A where a conductive bridge is used to form an electrical coupling;
Figure 4A shows a further light source system in accordance with an aspect of the present disclosure;
Figure 4B shows a circuit diagram representation of the system of Figure 4A;
Figure 5A shows a further light source system in accordance with an aspect of the present disclosure;
Figure 5B shows a circuit diagram representation of the system of Figure 5A;
Figure 6 shows a further light source system in accordance with an aspect of the present disclosure;
Figure 7A shows a further light source system in accordance with an aspect of the present disclosure;
Figure 7B shows a side on view of the system of Figure 7A;
Figure 8A shows a further light source system in accordance with an aspect of the present disclosure;
Figure 8B shows a circuit diagram representation of the system of Figure 8A;
Figure 9 shows a further light source system in accordance with an aspect of the present disclosure;
Figure 10A shows a further light source system in accordance with an aspect of the present disclosure;
Figure 10B shows a circuit diagram representation of the system of Figure 10A;
Figure 10C shows a side on view of the system of Figure 10A;
Figure 11A shows a further light source system in accordance with an aspect of the present disclosure;
Figure 11B shows a circuit diagram representation of the system of Figure 11A;
Figure 12 shows a further light source system in accordance with an aspect of the present disclosure;
Figure 13A shows a further light source system in accordance with an aspect of the present disclosure;
Figure 13B shows a side on view of the system of Figure 13A;

Figure 13C shows a further light source system in accordance with an aspect of the present disclosure;
Figure 13D shows a side on view of the first capacitor of the system of Figure 13C;
Figure 13E shows a side on view of the system of Figure 13C;
Figure 13F shows a further light source system in accordance with an aspect of the present disclosure;
Figure 13G shows a side on view of the system of Figure 13F; and
Figures 14A and 14B show representations of conductive clips that may be used to couple to the first capacitor to the supply voltage terminal.

## Detailed Description

Many factors may affect the precision with which a ToF camera system can measure distance to an object. One of those factors is the nature of the light emitted from the light source. For example, ambient light interference can affect accuracy of distance/depth determination. Typically, modulating the emitted light with a relatively high frequency modulation signal can reduce ambient light interference. However, the maximum achievable frequency may be limited by the rise and fall time of the signal driving the light source.

Furthermore, the range of accurate distance/-depth measurement may be limited by peak power of the emitted light. Increasing the peak power of emitted light, whilst staying within eye safety limits, may increase the maximum depth that can be accurately measured by the system.

The relationship between noise in the depth measurement, modulation frequency of the light source and number of detected signal photons can be seen from:

$$\sigma = \propto \frac{c\sqrt{A_{signal} + B_{background}}}{4\pi f_{mod}\sqrt{2}MCA_{signal}}$$

where:

$\sigma$ = depth noise
$c$ = speed of light
$A_{signal}$ = Mean number of detected signal photons
$B_{background}$ = Mean number of detected background photons
$f_{mod}$ = modulation frequency
$MC$ = modulation contrast

Increasing peak power of emitted light should increase $A_{signal}$. Increasing modulation frequency of the emitted light should also decrease overall depth noise uncertainty. By way of example only, the inventors have recognised that if the light source is a vertical cavity surface emitting laser (VCSEL), a good depth measurement range may be achieved and $\sigma$ may be kept within a desirable level if the light source driving signal can deliver a peak current in the region of 4A, with a rise and fall time in the region of 600ps. For imaging objects in the few meter range modulation frequencies may be in the region of 50 to 400MHz, and multiple frequencies may be used over multiple frames of capture to handle phase unwrapping at different distances. The modulated light is burst over a period in the region of 10's of microseconds (uS) every frame, often in the region of 10uS every 1-2mS for near throw applications, and in the region of 100's of microseconds (uS) for longer throw applications. However, it will be appreciated that the aspects disclosed herein are not limited only to these particular parameters and the system may be configured to deliver other levels of peak current, rise/fall times, modulation frequencies and burst periods.

Therefore, in order to improve both accuracy and measurement range, it is desirable to emit from the light source a high peak power light signal that is modulated with a relatively high frequency modulation signal. This requires a high a current drive signal to be delivered to the light source that achieves a high peak current in a relatively short rise and fall time.

However, there are many challenges in driving a light source with a relatively high current and a relatively short rise and fall time. In particular, inherent resistances and inductances in the light source driver circuits not only contribute to electrical losses (thereby increasing the amount of current needed to achieve a particular optical power output from the light source), but also slows circuit transitions between current levels, thereby slowing turn on and turn off.

With this challenge in mind, the inventors have devised various designs of light source system that are suitable for use in ToF camera systems. In those designs, the system includes a low-inductance current loop/circuit that is designed to supply a first part of the light source drive current with a very short rise and/or fall time. The low-inductance loop includes a first capacitor that is positioned in close proximity to the light source and is coupled to the light source and driver circuit. As a result of close proximity, the size of the current loop/circuit formed by the first capacitor, light source and light source driver is very small so that inductance is minimised. The first capacitor supplies the initial current for turning on the light source and, as a result of the low inductance of the loop the rise-time of the initial current may be very short. In addition, the required headroom of the driver current and power supply can be lower allowing a more power efficient solution.

Optionally, a second, higher inductance loop may also be present, the second loop including a second capacitor that is larger than the first capacitor and may replenish the charge on the first capacitor and/or drive the light source after initial turn on. The second capacitor is not coupled so closely to the light source and the light source driver. As such, the inductance of the current loop/circuit formed by the second capacitor, light source and light source driver is larger than the inductance formed by the first capacitor, light source and light source driver. In an alternative, the second capacitor may be omitted and the first capacitor may be replenished and the light source may be driven after the initial turn on by a supply voltage. In this way, the light source may be supplied initially with current in the lower inductance current loop, thereby improving current signal rise time, and then later supplied during the 'steady-state' period of the drive signal with current in a higher inductance current loop, enabling a high peak current to be sustained for the drive signal duration. Since the achieved rise time is most affected by the inductance of the drive circuit initially, a fast rise time and high peak current may be achieved. The supply voltage may provide the current needed to recharge both capacitors and sustain longer burst periods of current.

Various design details to minimise the inductance of the first current loop are also disclosed. For example, implementing the first capacitor as a vertical capacitor, such that part of the vertical translation of current between the plane of the substrate on which the components are mounted and the plane in which the upper terminal of the light source sits is performed by the first capacitor. This reduces/eliminates the need for any features that are dedicated purely to conducting current between those two planes, such as a conductive via, thereby reducing inductance even further. In a further example, the light source and the first capacitor may be mounted on a surface of the integrated circuit (IC) that contains the driver circuit, thereby minimising the physical size of the current loop formed, which further reduces inductance.

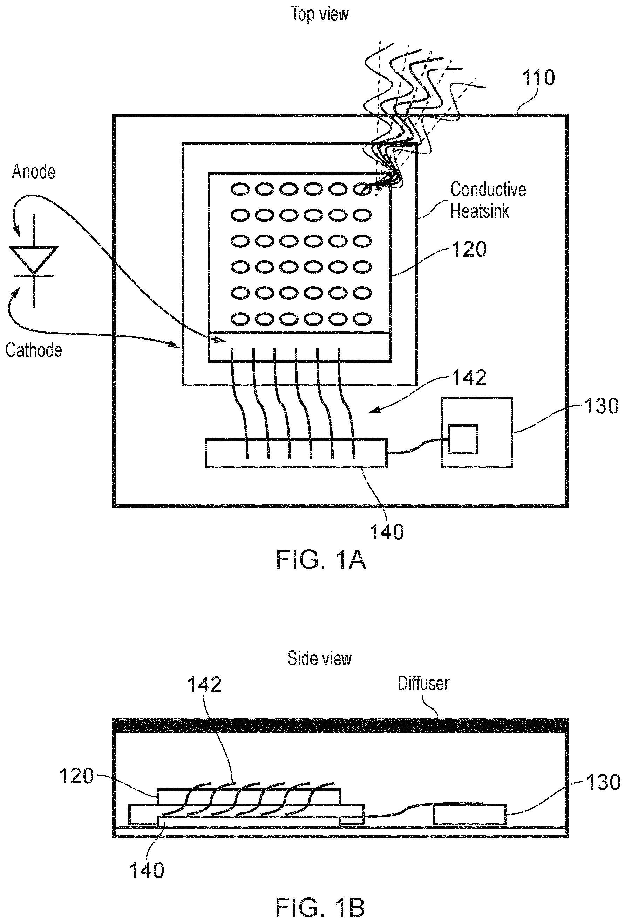

Figures 1A and 1B show example representations of a previous packaged light source module 110 that suffers from a relatively high inductance drive circuit and therefore relatively slow rise and fall times. The light source is a VCSEL and the packaged light source module 110 includes a VCSEL 120 and a photodiode 130 (which may be used to measure optical power out for eye safety reasons). An anode terminal 122 of the VCSEL 120 is coupled to a bond pad 140 via a wire bond 142 and the cathode terminal is on the underside of the VCSEL 110 (and therefore not visible).

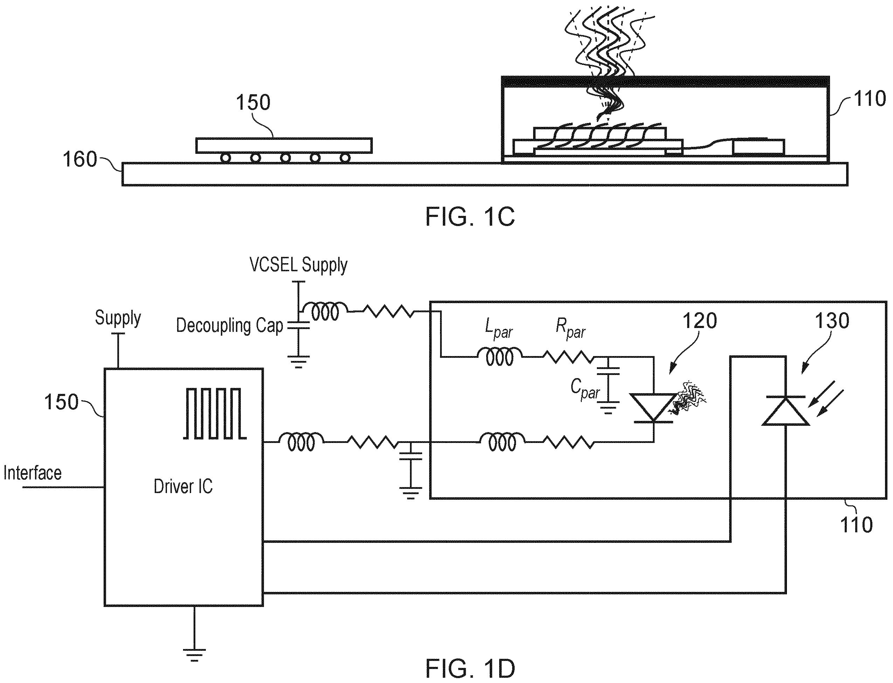

Figure 1C shows the packaged light source module 110 mounted on a PCB 160. The bond pad 140 and cathode terminal of the light source module 110 are coupled to a driver IC 150 via the PCB 160.

Figure 1D shows a circuit diagram representing the system 100, which includes representations of parasitic inductances, resistances and capacitances. It will be appreciated that there is a relatively high equivalent series inductance in the packaged VCSEL module 110, which combined with the PCB routing parasitics may inhibit the rise time of the current drive signal. They may also cause unwanted electrical resonance. The drop across the inductance during drive when there is fast change of current causes a voltage drop across the inductance that reduces the available voltage compliance/head room of the driver. To compensate for that, the power supply voltage may be increased, but this increases the power consumption during the laser driving period. A reduction in circuit inductance is therefore desirable to minimise power consumption during operation of the laser.

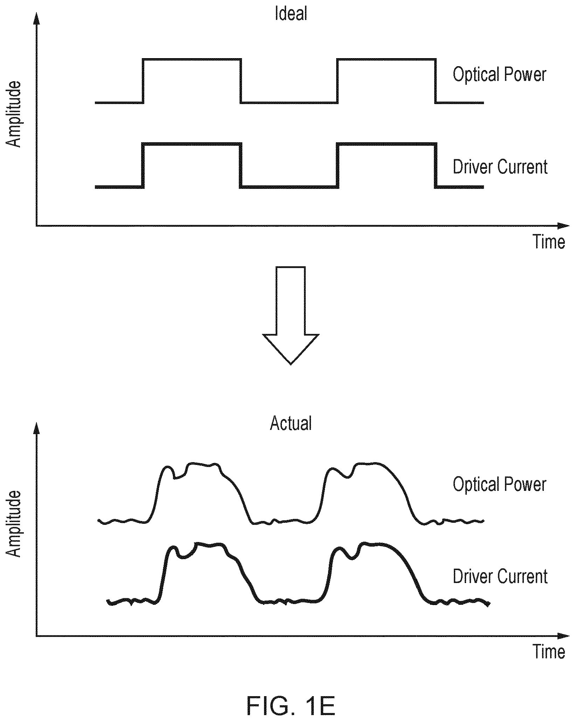

Figure 1E shows a representation of an ideal drive current signal and an ideal optical power signal, and the actual optical power and driver current realised by the arrangements of Figures 1C and 1D. As can be seen, the rise and fall times in driver current, and therefore also optical power out of the VCSEL 120, are slower than ideal. The drive signal to the VCSEL can consist of more than just a square wave. In particular, pre-emphasis or waveform shaping may be added to try control and improve the optical edge speed or spectral content, however they all fight the loop inductance.

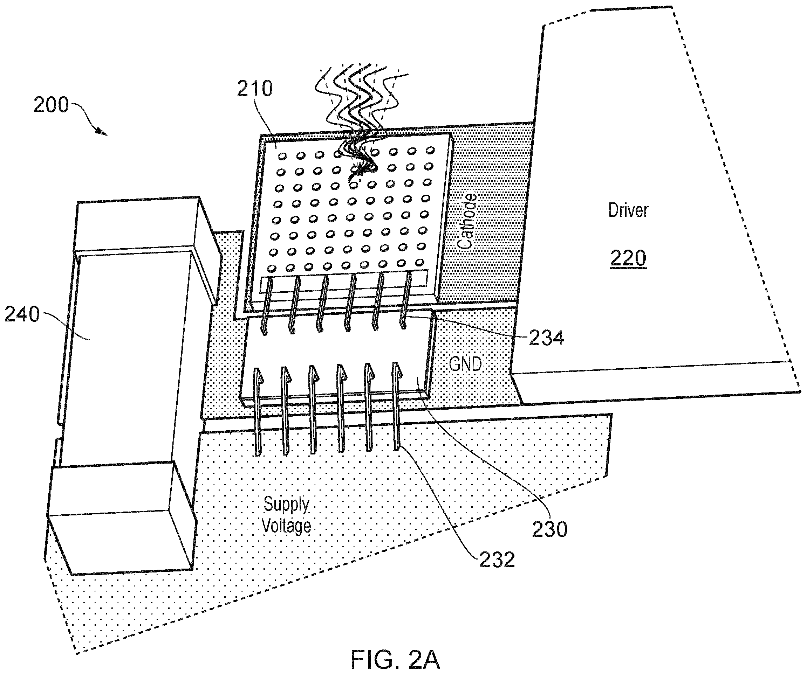

Figure 2A shows a light source system 200 in accordance with an aspect of the present disclosure. The system 200 includes a light source 210, in this case a VCSEL, a light source driver 220, a first capacitor 230 and a second capacitor 240. The first capacitor 230 in this example is a low inductance wire bonded vertical capacitor. It may be, for example, a silicon capacitor, such as a wire bondable vertical Si capacitor made by Murata - https://www.murata.com/- /med ia/webrenewal/products/capacitor/siliconcapacitors/pdf/silicon-capacitors-cataloguev15murata.ashx?la=en&cvid=20200227020954000000.

These vertical silicon capacitors can be made in silicon with some form of trenching to increase the effective surface of capacitance for a given area. The trenches may be lined with one electrode, coated with an insulator and then coated with a second electrode. The first electrode can then connect through heavily doped silicon to the bottom surface of the capacitor, which is then coated with a good metallic conductor to form a terminal so that it can be suitable for attachment in a system, through solder or equivalent. An upper electrode may be formed on the upper surface of the capacitor in a similar way to allow for wire bonding or other connection method. There are however other methods of making such capacitors.

An upper surface of the first capacitor 230 comprises an upper terminal for making connections to a first (top) plate of the first capacitor 230. The upper terminal is coupled to a voltage terminal, which in this example is the supply voltage trace (which may be any suitable voltage, for example 3.3V, or 5V, or 11V, etc, etc) by bond wires 232. The upper terminal of the first capacitor 230 is also coupled to an upper terminal (in this case, an anode terminal) on the upper surface of the VCSEL 210 by bond wires 234, such that two different connections are made to the upper terminal of the first capacitor 230. In this, when the VCSEL is on, current may be supplied to the anode terminal from the first capacitor 230 and the supply voltage (as explained later).

A mounting (lower) surface of the first capacitor 230 comprises a lower terminal for making connections to a second (bottom) plate of the first capacitor 230 (not visible in Fig 2A). The mounting surface of the first capacitor is conductively bonded to a reference voltage conductive path, which in this case is a ground trace of the PCB by any suitable means such as solder/bump bonding or conductive adhesive etc. The mounting (lower) surface of the VCSEL 210 comprises a lower terminal (in this case, a cathode terminal). The lower terminal is conductively bonded to a cathode conductive path (in this example a trace of the PCB) by any suitable means such as metal to metal bonding or conductive adhesive etc. The lower terminals of the VCSEL 210 and the first capacitor 230 are coupled to each other by the current driver 220 by conductively bonding (eg solder/bump bonding, conductive adhesive, etc) a first (current input) terminal of the driver 220 to the cathode trace and conductively bonding (eg die bonding, solder/bump bonding, conductive adhesive, etc) a second (current output) terminal of the driver 220 to the reference voltage trace, so that when the VCSEL is on current flows from the VCSEL cathode drive the driver 220 and returned to the bottom plate of the first capacitor 230, whose top plate is delivering the current to the anode of the same VCSEL 210.

In this example, all of the represented components/elements are mounted on an insulting substrate of a PCB. However, it will be appreciated that in this example implementation and all other example implementations below, other, non-PCB types of substrate may be used, for example ceramic substrates. It can be seen that the conductive paths (eg, traces) are all on the same side of the substrate such that interconnections, such as conductive vias, are not required, which helps to reduce the circuit length and inductance of the circuit.

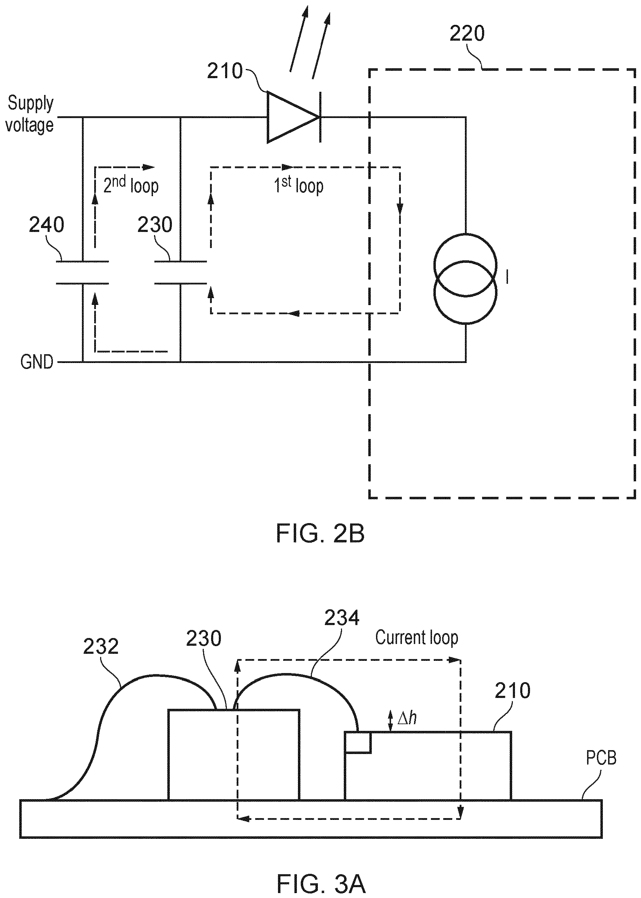

Figure 2B shows a circuit diagram representation of the configuration of the system 200. The driver 220 is represented as including a current source/sink, but no other components of the driver 220 are represented for the sake of simplicity (such as switches/transistors for turning the VCSEL drive current on and off). The driver 220 may comprise a transistor device such as a FET having a gate voltage controlled to bias the transistor to operate as a current source/sink. That transistor may also operate as a switch to turn the circuit current on and off, thereby controlling the VCSEL 210. Alternatively, the driver 220 may include a second transistor device may be provided in series with the current source and VCSEL, on either side of the current source, which may be operated as a switch to turn the circuit current on or off. Optionally, there can be a plurality of drive transistors to form a digitally controlled current, and the current can be modulated from one non-zero level to another non-zero level by the plurality of drive transistors, or by other means, to generate the required modulation of the light source from one level to another, and not just moving between driver current on and off. It can be seen that in this example, the driver 220 is operating as a low side driver since it is positioned at the cathode side of the VCSEL 210. Therefore, it will be appreciated that the driver/current driver 220 may alternatively be referred to as a controller/current controller configured to control the switching on and off or modulation of the current in the circuit.

The first capacitor 230 is positioned very close to the VCSEL 210 and the driver 220. As a result, the current loop formed by the first capacitor 230, VCSEL 210 and driver 220 is relatively short. The first capacitor 230 and VCSEL 210 may be positioned in the region of 100um, $200\mu m$, $500\mu m$, 1mm or 2mm away. Furthermore, the first capacitor 230 is a vertical capacitor, which may be selected to be of low inductance design such as a silicon vertical capacitor. The closer the first capacitor 230 is in height to the VCSEL 210, the closer the components may be positioned together and the shorter and less loopy the connection method may be. Therefore, the current loop formed by the first capacitor 230, VCSEL 210 and driver 220 is relatively short and relatively low inductance. However, as a result of a desire to have a very compact design, the capacitance value of the first capacitor 230 and therefore the amount of energy (current over a short period of time) that the first capacitor 230 may deliver to the VCSEL 210 may be relatively small. The second capacitor 240 is positioned further away from the VCSEL 210 and the driver 240 and may be of a relatively high inductance design (compared with the vertical capacitor). As a result, the current loop formed by the second capacitor 240, VCSEL 210 and driver 220 may be relatively long and a relatively high inductance (compared with the first loop). However, the second capacitor 240 may have a relatively high capacitance compared with the first capacitor 230 and therefore be capable of delivering a relatively large current to the VCSEL 210 with a relatively low rate of change of current, as the high frequency demands have been met by the first capacitor 230. The second capacitor 240 may be any suitable design or type or combination of capacitor, such as a ceramic capacitor, a polymer capacitor and/or combination of multiple types of capacitor. In one example, it may be an SMD capacitor mounted on the substrate on which the VCSEL 210 is mounted, or mounted elsewhere and connected by a cable or flex.

When the driver 220 turns on the drive current, because the first loop is relatively low inductance the first capacitor 230 should initially supply a first part of the driving current to the VCSEL 210. The relatively low loop inductance should result in a short rise time of that current, such that the high-frequency component of the driving current may be supplied by the first capacitor 230. The second capacitor 240 should supply a second part of the driving current to the VCSEL and the supply voltage should supply a third part of the driving current to the VCSEL, and also top up the first capacitor 230 and/or second capacitor 240. Owing to the relatively large loop inductance of the circuits that include the second capacitor 240 and the supply voltage, and the impedance of the supply voltage, the rise time may be relatively long compared with the first part of the current supplied by the first capacitor 230. However, the relatively large amount of current that can be supplied by the second capacitor 240 and the supply voltage should enable the circuit to sustain a large peak current for the duration of the drive signal. Therefore, this arrangement means that a high drive current (for example, in the order of 4A, such as 3.5A or 4.5A, or beyond) may be achieved with a relatively fast switching/rise time (for example, in the order of 500ps, such as 460ps, or 520ps, etc) at a high modulation frequency (for example in the order to 10MHz to 500MHz or beyond) for an overall illumination operation period in the 10s or 100s of $\mu$s.

The first capacitor may be in the region of 10's-100's nF to deliver current over part of a few cycles of the modulation frequency with only a few hundred mVs of ripple, while the second capacitor may be significantly larger (uFs to 100's uF) to sustain the current delivery for 10's or 100's uS and/or to smooth out the current draw from the power supply for many periods of the modulation frequency within the burst.

The height of the first capacitor 230 (i.e., the distance between the upper surface of the first capacitor 230 and the surface of the substrate on which it is mounted) may be chosen such that it is substantially (for example, within 5%, or within 10%, or within 25%) the same height as the VCSEL 210 (i.e., the distance between the upper surface of the VCSEL 210 and the surface of the substrate on which it is mounted). Typically a VCSEL may have a thickness in the range of 100$\mu$m or 120$\mu$m. They are typically in this range to minimise the thickness to improve heat transfer out of the VCSEL and reduce its series impedance, while maintaining a thickness that keeps the necessary rigidity for handling and reliability. However, it may be possible now or in the future to have VCSELs and other light emitting devices that are thinner or thicker. Also this thickness may be subject to manufacturing tolerances in the region of 5% or 10%. It will therefore be appreciated that the term "substantially" does not mean that the two components are exactly the same height. Instead, it means that they are at least close to being at the same height, within manufacturing tolerances and/or within a reasonable approximation given the limitations of choice of physical device dimension. In particular, if the device heights are the same to within 20-30% of each other, such as to within 25%, significant benefits may be realised. For example, if a VCSEL has a nominal thickness of 100$\mu$m, a first capacitor 210 having an upper terminal at substantially the same height as from the substrate as an upper terminal of the VCSEL may have a nominal thickness anywhere in the range of 70-130$\mu$m (i.e., within +/- 30%), or anywhere in the range of 80-120$\mu$m (i.e., within +/- 20%).

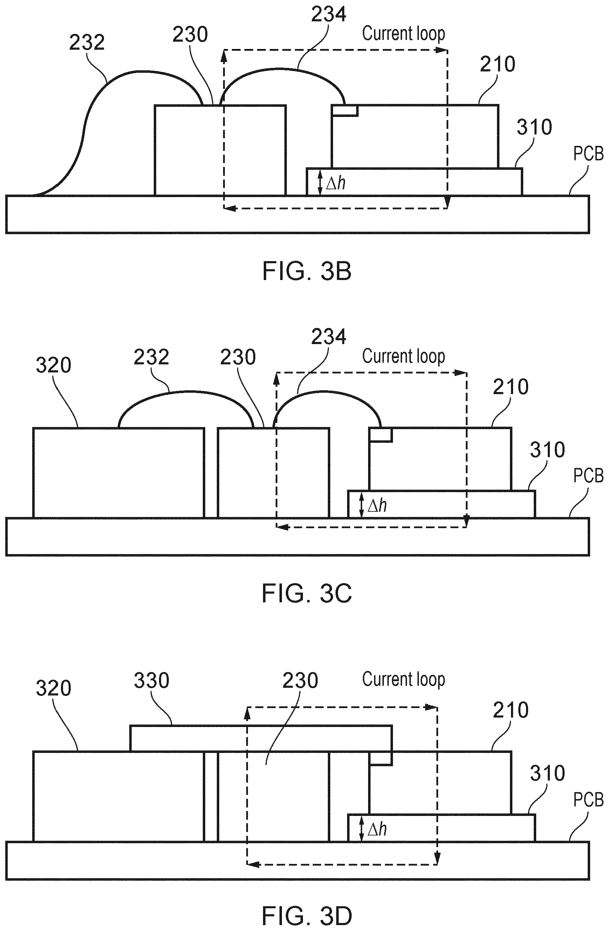

In particular, the length of the bond wires 234 may be minimised both by virtue of the bond wire having to travel less vertical distance, but also because it enables the first capacitor 230 and VCSEL 210 to be positioned closer to each other. This minimises parasitic inductance and resistance associated with the bond wires. Furthermore, the amount of "loop" of the bond wires 234 may be reduced, which even further reduces the inductance associated with the bond wires 234. This can be understood further with reference to Figure 3. Furthermore, the capacitor may perform most if not all of the vertical translation of current required to initially drive the VCSEL 210 such that components dedicated only to vertical conduction of current are not required, thereby reducing inductance even further.

Whilst the above described vertical capacitor 230 is of a silicon design, other types of vertical capacitor may alternatively be used. For example, there are vertical capacitors that can be coated on the surface of the substrate, for example coated onto the reference voltage trace in the example of Figure 2A, and have the three conductive conditions made to its two plates in the same way as described above with reference to Figure 2A. Such a capacitor may be relatively thin compared with the VCSEL 210 such that they are not at substantially the same height. However, such a design still means that a part of the vertical translation of current from the substrate surface to the VCSEL upper terminal is performed by the first capacitor 230, which helps to reduce inductance compared with arrangements where all of the vertical translation is done by components performing only current conduction, such as vias. Furthermore, the design enables the first capacitor 230 to be positioned at very close proximity to the VCSEL 210, thereby minimising the size of the current loop and reducing inductance. Therefore, even when the first capacitor 230 is a vertical capacitor having a height that is not substantially the same as the height of the VCSEL 210, the system may still achieve reduced inductance and therefore faster speeds of current transition/change by virtue of the vertical capacitor performing a part of the required vertical current translation and/or enabling a more compact circuit arrangement.

Further optionally, depending on the dimensions of the first capacitor 230 and the VCSEL 210, a podium (also referred to as a "slug") may be used to raise the upper surface of the first capacitor 230 and/or VCSEL 210 to bring their upper surfaces substantially co-planar. Figure 3A shows an arrangement where a height difference $\Delta h$ exists between the upper surface of the first capacitor 230 and the upper surface of the VCSEL 210. The VCSEL 210 may be mounted on a conductive material, such as copper, to form a conductive coupling between the cathode of the VCSEL 210 and the conductive traces of the PCB. The first capacitor 230 and the VCSEL 210 may be chosen so that any height difference $\Delta h$ that might exist between them is sufficiently small that they may be considered to be at substantially the same height. However, in cases where the height difference $\Delta h$ is relatively large, a podium or slug may be used to make the height of the components (i.e., the distance between the surface of the PCB and the upper terminals of the components) substantially the same.

Figure 3B shows an example where a podium 310 (or "slug" or "shim") is used to raise the height of the VCSEL 210 first capacitor 230 so that its upper surface is at substantially the same height as the top surface of the first capacitor 230. The podium may be made of any suitable conductive material, such as copper, and is therefore similar to the conductive material described above with reference to Figure 3A, but has a height that is chosen particularly to reduce or eliminate the height difference Δh. The surface area of the podium 310 may be similar to the surface area of the component it is elevating, in this case the VCSEL 210, with the podium positioned on the surface of the substrate between the surface of the substrate and the VCSEL 210. As a result, the length of wire bonds 234 may be reduced, which reduces parasitic inductances and resistances. Furthermore, it can be seen that the bond wires 234 in Figure 3B have less "loop" than the bond wires 234 in Figure 3A (i.e., the radius of the loop formed by the bond wires 234 is effectively reduced) and therefore have even further reduced inductance.

It will be appreciated that depending on the geometries of the first capacitor 230 and the VCSEL 210, the podium 310 may alternatively be used to raise the height of the first capacitor 230, for example where the VCSEL 210 height is higher than that of the first capacitor 230 such that the podium 310 may be positioned under the first capacitor 230 to raise its top surface to be substantially co-planar with the upper surface of the VCSEL 210. In any event, it will be understood that a podium such as 310 in Figure 3B may be used in any of the aspects disclosed herein to bring the terminals of the first capacitor 230 and VCSEL 210 that are coupled together with bond wires 234 to a substantially co-planar height.

Figure 3C shows an even further configuration, where an additional conductive podium 320 is used to raise the height of the bond wire coupling point between the bond wires 232 and the conductive traces of the PCB. The conductive podium 320 may be made of any suitable conductive material, such as copper. By raising the height of the point at which the bond wires 232 are electrically coupled to the supply traces of the PCB, the amount of "loop" of the bond wires 232 may be decreased, thereby even further reducing the inductance of the bond wires 232. The podium 320 may be used in addition or as an alternative to podium 310.

Figure 3D shows an alternative configuration where rather than using bond wires for the couplings between the supply terminal, the first capacitor 230 and the VCSEL 210, a conductive "bridge" 330, for example a sheet of any suitable conductive material such as copper, may be used to achieve the conductive couplings. The bridge 330 may be fixed to the first capacitor 230 and the VCSEL 210 anode terminal using conductive adhesive. By doing so, not only is the current loop as small as possible because the surfaces of the first capacitor 230 and VCSEL 210 are substantially co-planar, thereby reducing inductances of the loop, other inductances associated with bond wires (such as inductances cause by their "looping" shape) may be reduced or eliminated. Furthermore, the impedance of the coupling may be reduced compared with bond wires by virtue of the increased conducting area. Other example alternatives to the use of bond wires are given later.

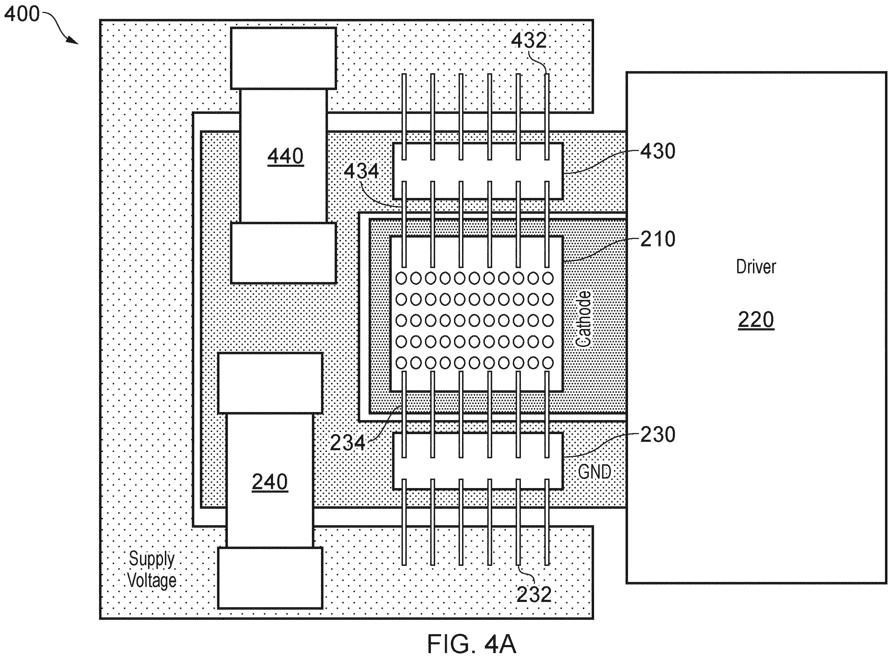

Figure 4A shows a further light source system 400 in accordance with an aspect of the present disclosure. It is similar to the first system 200, but includes a third capacitor 430 that is of the same design as the first capacitor 230, and a fourth capacitor 440 that is of the same design as the second capacitor 420. The VCSEL 210 has two upper terminals on its upper surface, with the first capacitor 230 coupled to one of those terminals by bond wires 234 and the third capacitor 430 coupled to the other terminal by bond wires 434. The third capacitor 430 is also coupled to the supply voltage conductive path by bond wires 432.

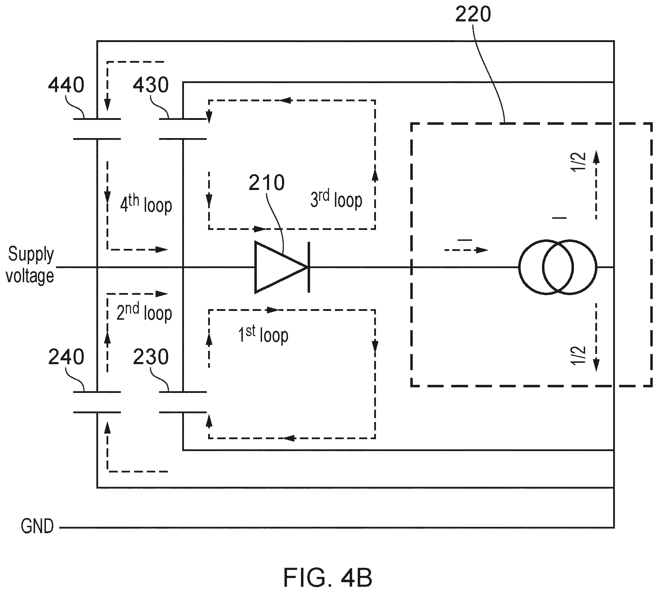

Figure 4B shows a circuit diagram representation of the configuration of the system 400. As can be seen, the first capacitor 230 and the third capacitor 430 are each part of relatively lower inductance current loops (1st loop and 3rd loop). The second capacitor 240 and the fourth capacitor 440 are each part of relatively higher inductance current loops (2nd loop and 4th loop). The operation of the system 400 is very similar to that of system 200. However, by doubling the number of bond pad connections on the VCSEL 210 compared with system 200, the bond wire inductance may be reduce by approximately half, thereby even further reducing the inductance of the current loop and improving the rise time of the drive current. Furthermore, it may be possible to deliver more current by using more capacitors and/or deliver the same current with smaller capacitors which may then be physically closer to the VCSEL 210 and the driver 220, thereby even further reducing inductance of the current loops and even further reducing rise/fall time of the current. In addition, owing to the symmetry of the layout, current flows in substantially the opposite direction in the 1st loop compared with the 3rd loop, and in the 2nd loop compared with the 4th loop. Consequently, there may be some magnetic field cancelling which can reduce electromagnetic emissions and reduce the effective inductance seen by each part of the system.

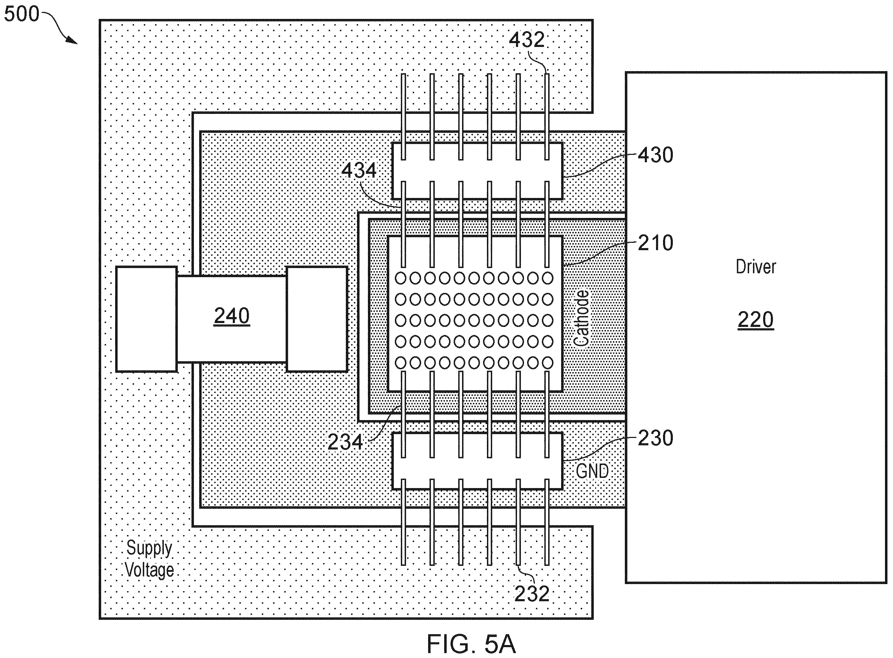

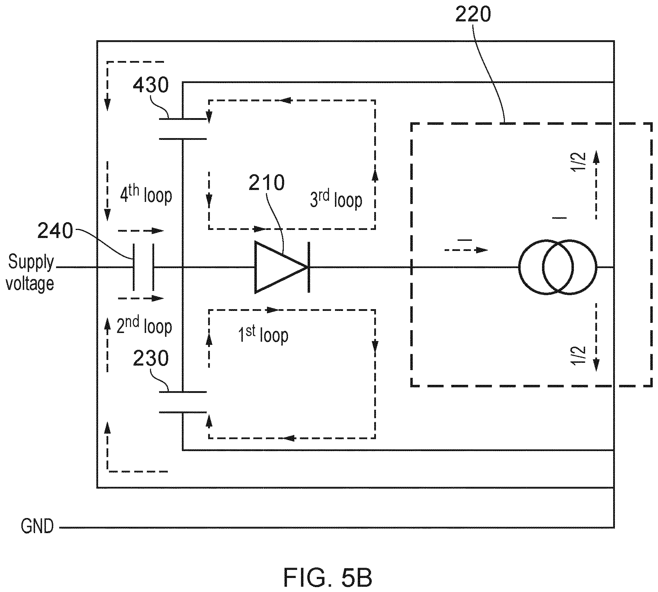

Figure 5A shows a further light source system 500 in accordance with an aspect of the present disclosure. It is very similar to the system 400, but does not include the fourth capacitor 440. Figure 5B shows a circuit diagram representation of the configuration of the system 500. In this example, the same benefit of doubling the bond pad connections as explained with reference to system 400 may be achieved. As will be appreciated from Figures 5 A and 5B, owing to the symmetry of the layout, current flows in the opposite direction in the 1st loop compared with the 3rd loop. Furthermore, effectively two current loops are formed between the second capacitor 240 and the other components of the circuit, such that there are again 2nd and 4th

loops with currents flowing in substantially the opposite direction. Consequently, there may be some magnetic field cancelling which can reduce electromagnetic emissions and reduce the effective inductance seen by each part of the system.

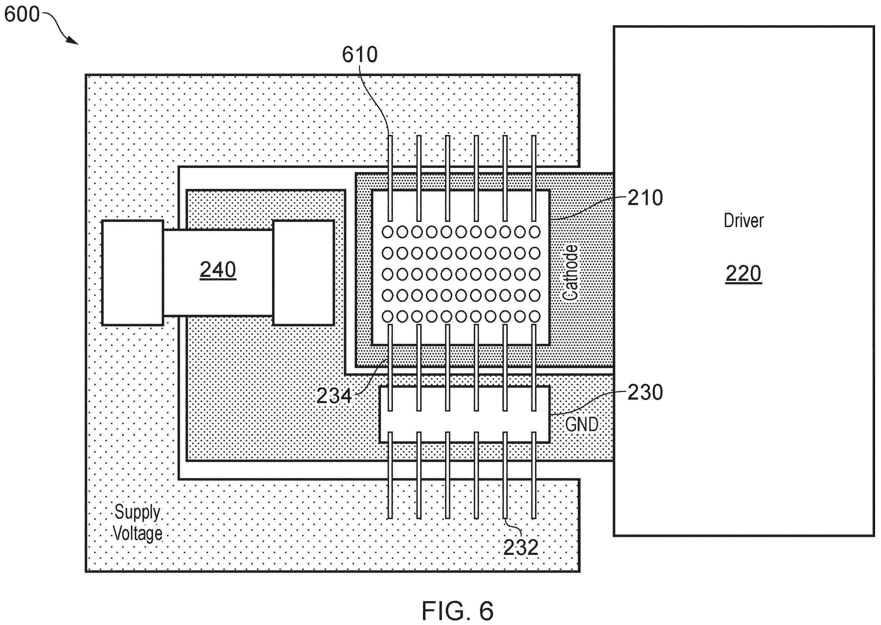

Figure 6 shows a further light source system 600 in accordance with an aspect of this disclosure. System 600 is very similar to system 500, but does not include a third capacitor 430 and instead includes bond wires 610 for coupling the second upper terminal of the VCSEL 610 to the supply voltage. Therefore, the second capacitor 240 is coupled to the VCSEL 210 via two routes, one route via the first plate of the first capacitor 230 and a second route via the bond wires 610. Optionally, a conductive platform may be used to raise the point at which the bond wires 610 couple to the supply voltage trace (similarly to Figure 3D) such that both ends of the bond wires 610 are at substantially the same distance from the surface of the substrate on which the components are all mounted.

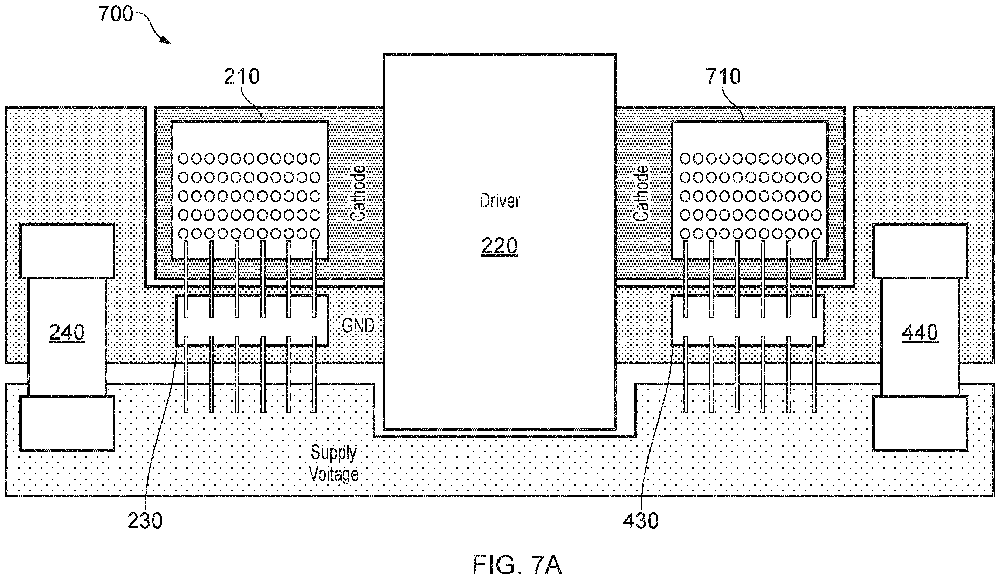

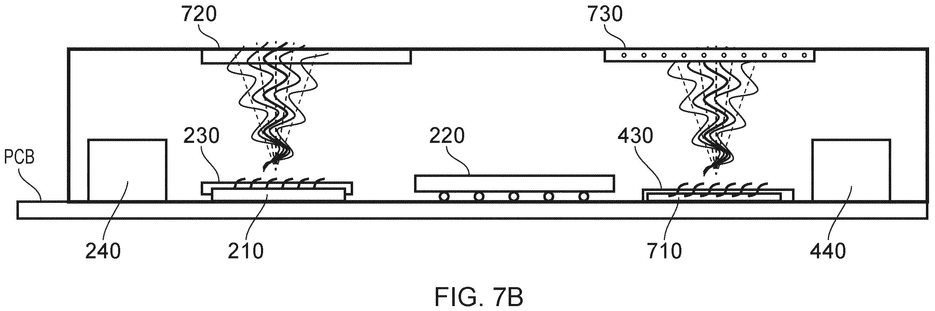

Figure 7A shows a further light source system 700 in accordance with an aspect of the present disclosure. The system 700 is very similar to the systems described above, but includes a second VCSEL 710 that is driven by the same driver 220 as the first VCSEL 210, but has separate low inductance and high inductance current loops formed by the third capacitor 430 and fourth capacitor 440. Optionally, the driver 220 may be configured to drive both VCSELs at the same time to increase optical output power, or may be configured to drive only one at a time, for example where they are configured to perform two different functions (such as described with reference to Figure 7B)

Figure 7B shows a side on view of the system 700 where the two different light sources are configured to perform different functions. Optionally, two different optical elements may be used for the two VCSELS. In this example, optical element 720 is a diffuser and optical element 730 is a diffractive optical element for creating a patterned light source. It will be appreciated that for each VCSEL any suitable/desired optical element may be used, or no optical element may be used at all.

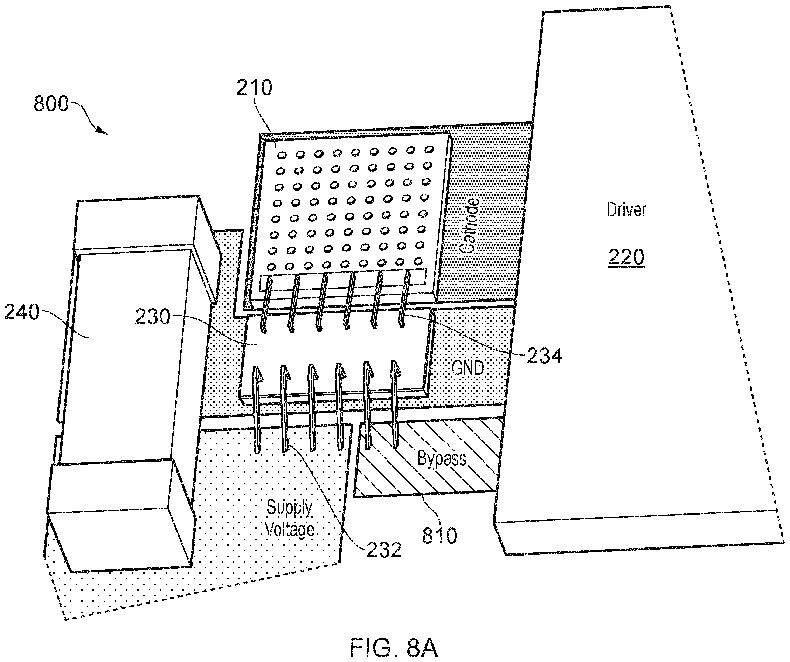

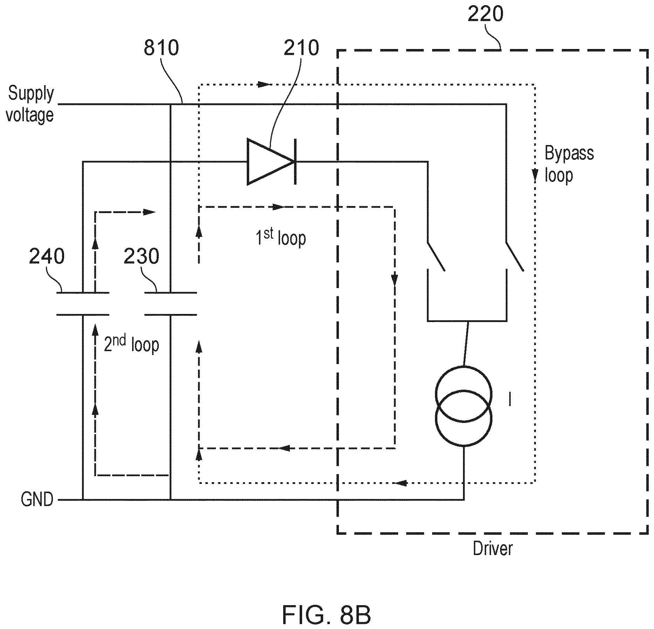

Figure 8A shows a further light source system 800 in accordance with an aspect of the present disclosure. Figure 8B shows a circuit diagram representation of the configuration of the system 800. The system 800 is very similar to the system 200 described earlier, except it includes a VCSEL bypass 810 and the driver 220 includes bypass circuitry. In this configuration, the driver 220 may maintain a continuous flow of current, switching between the bypass loop and the VCSEL 210 drive loops in order to turn the VCSEL 210 on and off. By doing so, a continuous flow of current through some parasitic inductances may be maintained, thereby reducing the effect of those parasitic inductances and reducing rise and fall time of the VCSEL drive current. As can be seen in Figure 8A, the upper terminal of the first capacitor 230 is wire bonded to the bypass 810.

In each of the examples described above, the first capacitor 230 is a vertical capacitor. Using a vertical capacitor in the light source system may significantly reduce loop inductance compared with previous circuits that use other forms of capacitor. In particular, it will be appreciated that the VCSEL is a vertical structure in that current flows between terminals on its upper and low surface when it is on. As a result, the circuit must also have a second, return path for current in the opposite direction.

In many traditional systems, the VCSEL may be mounted on a multi-layer substrate, with one vertical layer for each voltage potential, such that there may be three layers: one for the ground terminal, another for the cathode voltage and another layer carrying the supply terminal. Components of the circuit may be mounted on the top surface of the substrate with conductive vias providing the appropriate vertical connections to lower surfaces of the substrate. However, those vias contribute to the overall inductance of the circuit.

As can be seen in Figures 3A to 3D, in the present disclosure by using a vertical capacitor for the first capacitor 230, the first capacitor 230 may perform at least some of the required vertical current translation in the opposite direction to the current flow through the VCSEL 210 i.e., carrying the current up to the level of the anode terminal of the VCSEL 210. Consequently, the first capacitor 230 effectively performs two functions: supplying some driving current and providing vertical current translation. As a result, component features serving the purpose of only vertical current translation, such as vias, may be avoided and loop inductance reduced.

This characteristic may be particularly beneficial with the "podium" implementations of Figures 3B to 3D. It can be seen in those figures that there are now effectively two lateral or horizontal planes, one higher voltage plane at the anode surface of the VCSEL 210 and one lower voltage plane at the PCB for the cathode terminal and ground. There are effectively also two vertical or translation current paths between the lateral planes: one formed by the VCSEL 210 and podium 210 to carry current from the higher voltage level/plane to the lower voltage level/plane and the other formed by the first capacitor 230 carrying current from the lower voltage level/plane to the higher voltage level/plane. This results in a significantly shorter overall current loop and reduced inductance compared with other solutions where conduction only paths, such as vias, are required to move between different levels/layers of the system.

It will be appreciated that the current paths shown in Figures 3A to 3D are simplified in that the current will also flow through the driver 220 that is mounted on the PCB but not shown in the Figures for the sake of simplicity. However, it will be appreciated that since the driver 220 is mounted on the PCB, which is the low voltage plane of the system, the current will flow from a cathode trace of the PCB on which the VCSEL 210 is mounted, through the driver 220 to the ground trace of the PCB and then up to the high voltage plane of the system via the first capacitor 230. Consequently, the current is being translated from the low voltage plane to the high voltage plane via the first capacitor 230, thereby obviating the need for a conductive path to be provided to perform that function.

In an alternative configuration, the first capacitor 230 (and optionally the third capacitor 430) may be a lateral capacitor, rather than a vertical capacitor. For example, it may be an interdigitated silicon lateral capacitor. This type of capacitor is often similar in construction to the vertical capacitor previously described in that it utilises trenches or other means such as pillars to increase the effective surface density of the capacitor, by means of layers of electrodes and insulators. However, in contrast to a vertical capacitor, both terminals are brought through to the same surface to facilitate connections to the two plates of the capacitor. These capacitors may optionally interdigitate rows of the electrode connections to reduce the parasitic resistance and inductance.

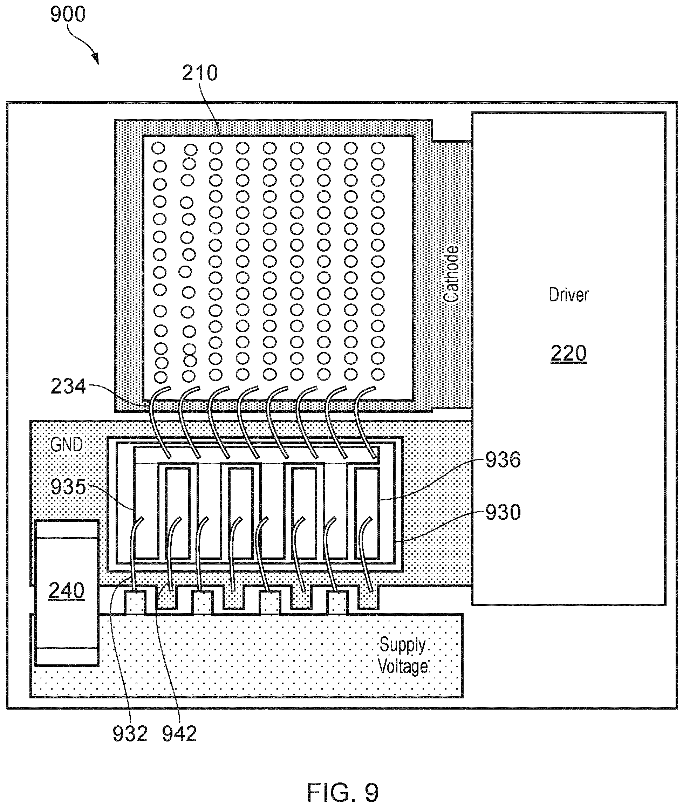

Figure 9 shows an example representation of such a capacitor implemented within the system 900 that is similar to the system 200. As can be seen, the first plate 935 of the first capacitor 930 is wire bonded to the supply voltage trace by bond wires 932 and wire bonded to the VCSEL 210 anode by bond wires 234. Second plates 936 of the first capacitor 930 are interdigitated with the first plates 935 and are wire bonded to the ground trace by wire bonds 942 (as opposed to the underside bonding used for the vertical capacitor design described earlier). As a result, just as with the vertical capacitor implementations, the two-terminal capacitor has three different connections made to it. Interdigitating the plates may help to cancel inductance between the wire bonds 932 to the supply voltage and the wire bonds 942 to ground, since the respective wire bonds are also interdigitated and have current flowing in opposite directions to each other. Therefore, arranging the plates of the first capacitor 930 in this way such that the bond wires between supply voltage to the first plates and between ground to the second plates are interdigitated may help to reduce the inductance of the lower inductance current loop of the drive circuit.

Furthermore, the inductances of the current loops may be even further reduced by having the different couplings within the loops at substantially the same height. For example, the height of the first plate 935 terminals may be substantially coplanar with the anode terminal of the VCSEL 210 and the PCB traces are all on one surface so that the coupling between the cathode of the VCSEL, the drive and the ground trace are all substantially coplanar. Therefore, again there are substantially only two planes of current flow around the low inductance loop, with the current moving between the two planes only through the VCSEL and through the bond wires 932 and 942. Again, one or both of the platforms described with reference to Figures 3B and 3C may be used if needed.

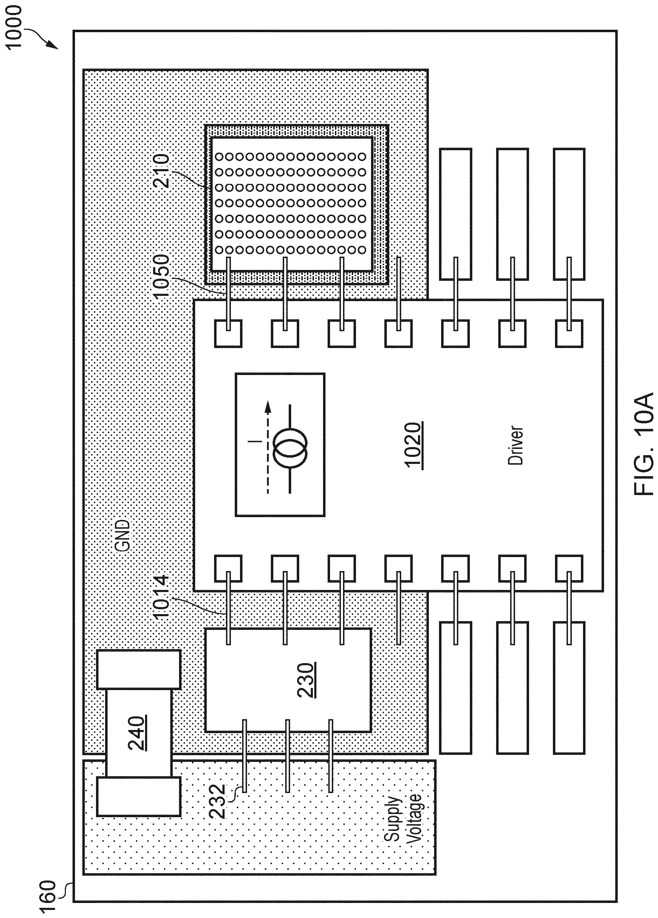

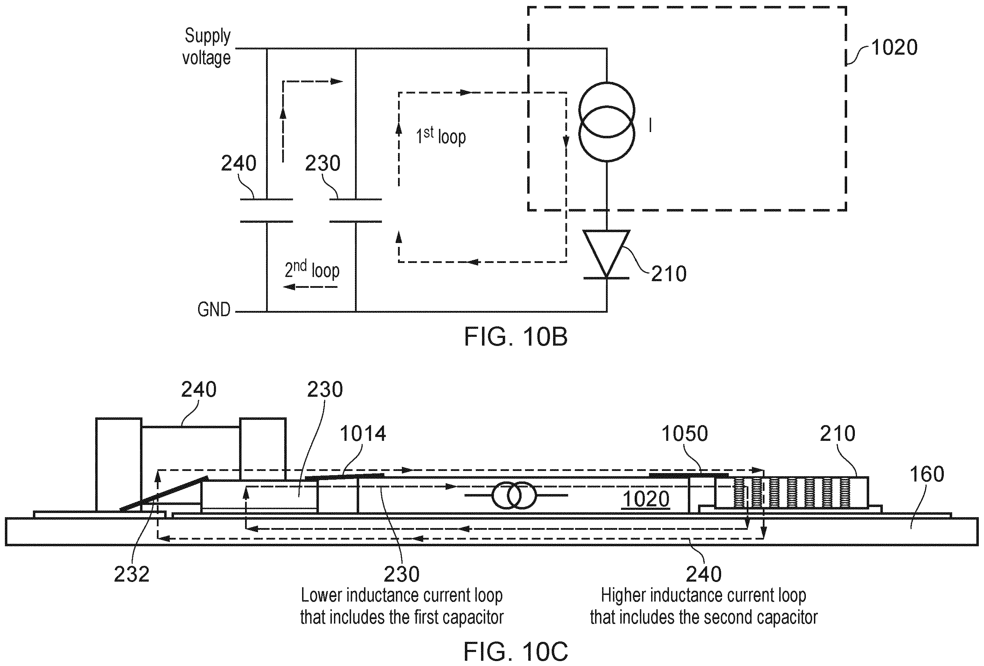

Figure 10A shows a further light source system 1000 in accordance with a configuration of the present disclosure. Figure 10B shows a circuit diagram representation of the configuration of the system 1000. In this system, the driver 1020 is configured as a high side driver of the VCSEL 210 (therefore, the drive transistor of the driver 1020 may be a PMOS transistor, rather than an NMOS transistor as typically used for low side drivers), such that the upper terminal of the first capacitor 230 is coupled to the upper terminal of the VCSEL 210 by the driver 1020. In particular, the upper terminal of the VCSEL 210 is coupled to a second (output current) terminal(s) of the driver 1020 by bond wires 1050 and the upper terminal of the first capacitor 230 is coupled to a first (input current) terminal(s) of the driver 1020 by bond wires 1014, such that when the VCSEL 210 is on current flows from the first capacitor 230 to the first terminal of the driver 1020, then from the second terminal of the driver 1020 to the VCSEL 210. Figure 10A also shows further terminals of the driver coupled to additional terminals of the PCB, but these are merely optional connections for purposes such as controlling the driver and will not be described further. The lower terminals of the VCSEL 210 and first capacitor 230 may be coupled to each other by conductively fixing them to the reference voltage conductive path (eg, the ground trace) of the PCB 160 by any suitable form of electrical coupling, such as metal to metal bonding or conductive adhesive which cannot be seen in the representation of Figure 9A. Such an arrangement may help to reduce ground loop inductance, thereby further reducing the rise time of the VCSEL drive current. In particular, the size of the current loop may be minimised by constraining the current to travel in substantially two planes - a first plane being the ground trace of the PCB substrate and a second plane being a plane in which the terminals on the upper surfaces of the first capacitor 230, the driver 1020 and the VCSEL 210 sit. In the low inductance loop, the current travels from the ground plane to the terminal connections plane through the first capacitor 230 and travels from the terminal connections plane to the ground plane through the VCSEL 210. The benefits of using the first capacitor 230 not only as a supply of charge but also to connect the ground plane to the terminal connections plane is described earlier. Furthermore, in this particular arrangement, the driver is mounted on the substrate over the part of the reference voltage trace through which the current returns from the VCSEL 210 to the first capacitor 230. For example, it may be fixed to the substrate in an insulated way so that current can pass underneath the driver 1020. This means that in both the high and low inductance current loops, current flows in substantially one direction in the ground plane and the opposite direction in the terminal connections plane. Therefore, a degree of loop inductance cancelation may be achieved, thereby even further reducing the inductance of each loop.

Figure 10C shows a side on representation of the system 1000 where the flow of current in the two current planes may be more readily appreciated.

Optionally, the upper surfaces of the first capacitor 230, the driver 1020 and the VCSEL 210 may be at substantially the same height from the surface of the substrate. This may be achieved through component selection and/or by having the driver 1020 IC relatively thinned in order to reduce the height of the driver 1020. Additionally or alternatively, one or more conductive platforms may be used to raise the height of one or more of the first capacitor 230, the VCSEL 210 and/or the driver 1020, so as to bring their terminals to substantially the same height from the PCB surface. Additionally or alternatively, one or more conductive platforms may be used to raise the height of the supply voltage bond wire terminals so that the bond wires 232 are bonded to a conductive platform that is substantially co-planar with the bond wire terminals on the surface of the first capacitor 230. As will be appreciated from the earlier description, these characteristics may help even further reduce loop inductance.

The lower terminal connections of the VCSEL 210 are coupled to the PCB substrate 160, which may improve heat dissipation of the VCSEL 210. The first capacitor 230 in this example is a vertical capacitor, although it will be appreciated that the lateral capacitor implementation of Figure 9 may also be used in combination with a high side driver.

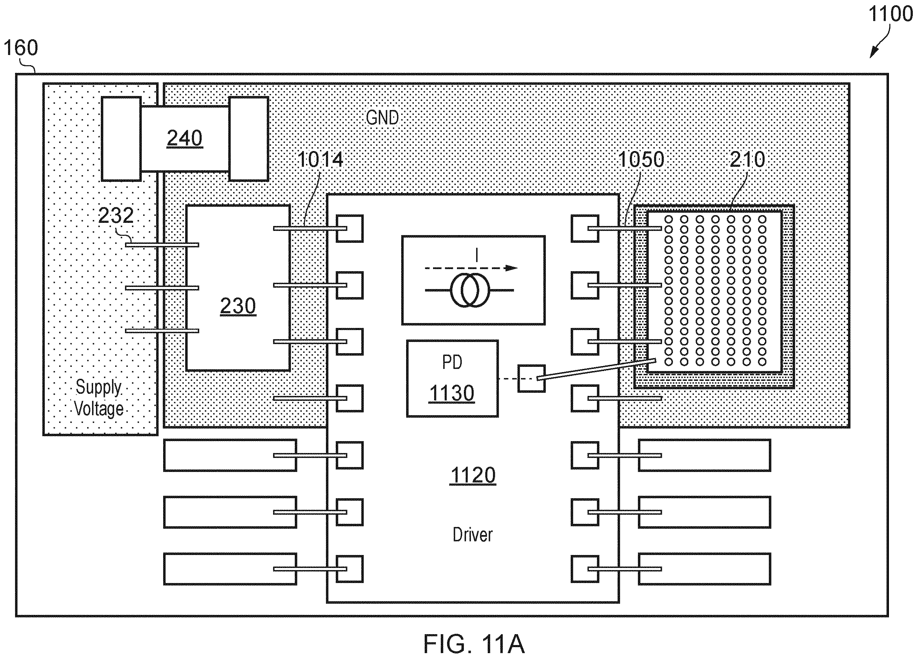

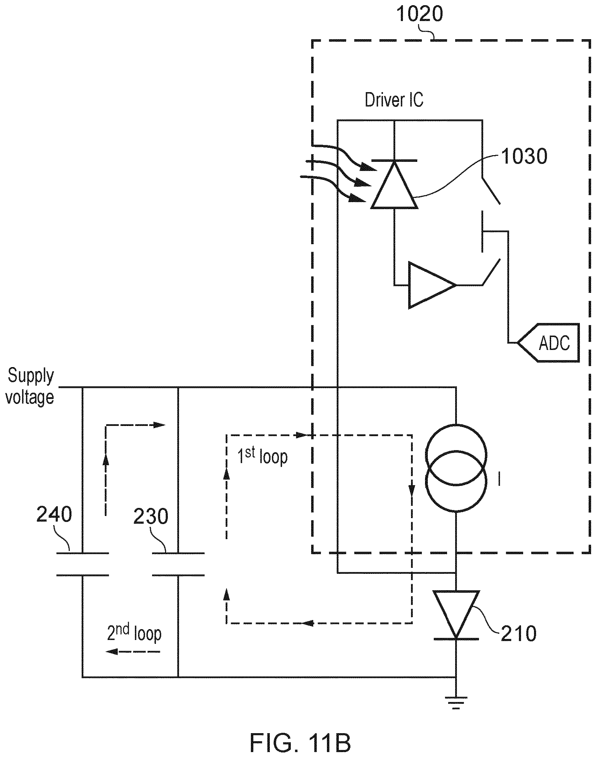

Figure 11A shows a further light source system 1100 in accordance with an aspect of the present disclosure. Figure 11B shows a circuit diagram representation of the configuration of the system 1100. This system is very similar to system 1000, but the driver IC 1120 further includes an integrated photodiode 1130. The photodiode 1130 is coupled to the upper terminal of the VCSEL 210 by an electrical connection internal to the driver IC 1020 and a bond wire. It may alternatively be coupled to the first capacitor 230 and/or internal routing of a reference voltage in the driver 1020. The photodiode 1130 is for use in measuring the intensity of light emitted from the VCSEL 210 for eye safety reasons, taking in light reflected back from any optical component in the light output path, such as a diffuser. As can be seen, the driver IC 1120 includes further components, such as a buffer/amplifier and ADC for use in measuring the light intensity. The photodiode 1130 may be embedded inside the driver IC, as it is also facing upwards, and this could allow for a simpler lower cost solution without the extra component. It should also be noted that there are several different ways to configure the photodiode 1130 and to use it for detection of representative light from the VCSEL 210, for example it could be referenced to another supply voltage, or it could be used to discharge a capacitor over the illumination period to create a low pass filtered version of the captured optical energy. In this particular example, the driver IC 1120 also includes switches that can be used to switch between measuring light intensity and measuring the voltage on the VCSEL 210 anode. The configuration of system 1100 results in a compact, low parasitic inductance design with built in safety features.

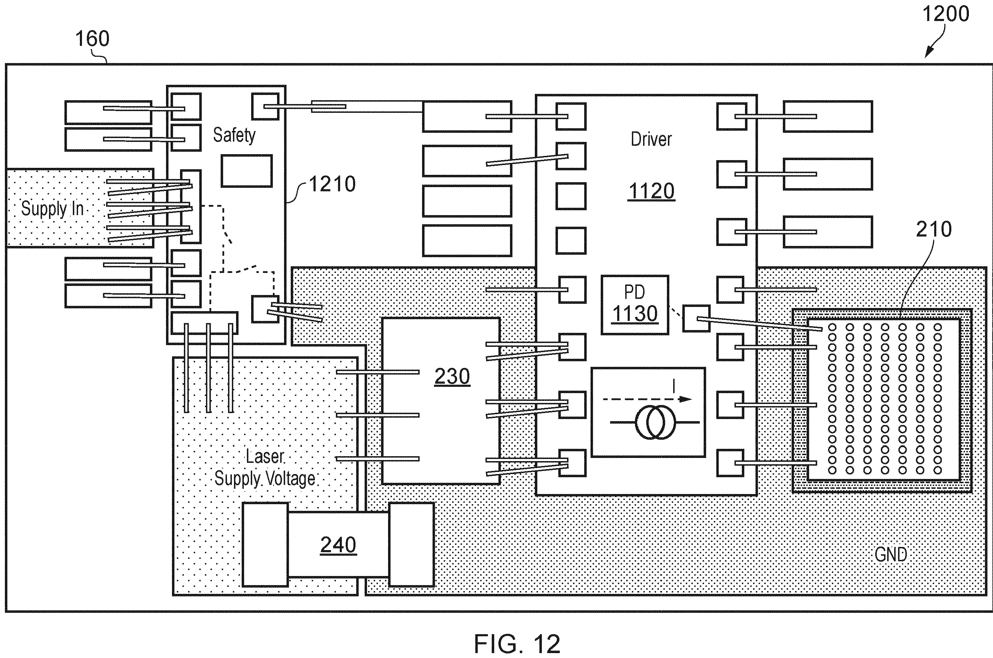

Figure 12 shows a further light source system 1200 in accordance with a configuration of the present disclosure. In this example, the system 1200 includes a wire bonded further safety monitoring IC 1210. The safety monitoring IC 1210 includes an integrated photodetector configured to measure the intensity of the light emitted from the VCSEL 210. The safety monitoring IC 1210 includes integrated switches to disconnect the power supply coming into the system 1200, or to shunt the voltage to the driver 1120 to 0V, thereby shutting off the system in the event of dangerous levels of light emission being detected. By having safety monitors in two different dies, this system 1200 provides additional redundancy in safety monitoring of the system, since a fault detected either by the safety monitoring IC 1210 or the PD 1130 monitoring within the driver IC 1120 may shut off the system so that light emission ceases. Whilst the safety monitoring IC 1210 is used in combination with the system arrangement of Figure 11A, it will be appreciated that it may be used in combined with any of the other system designs disclosed herein.

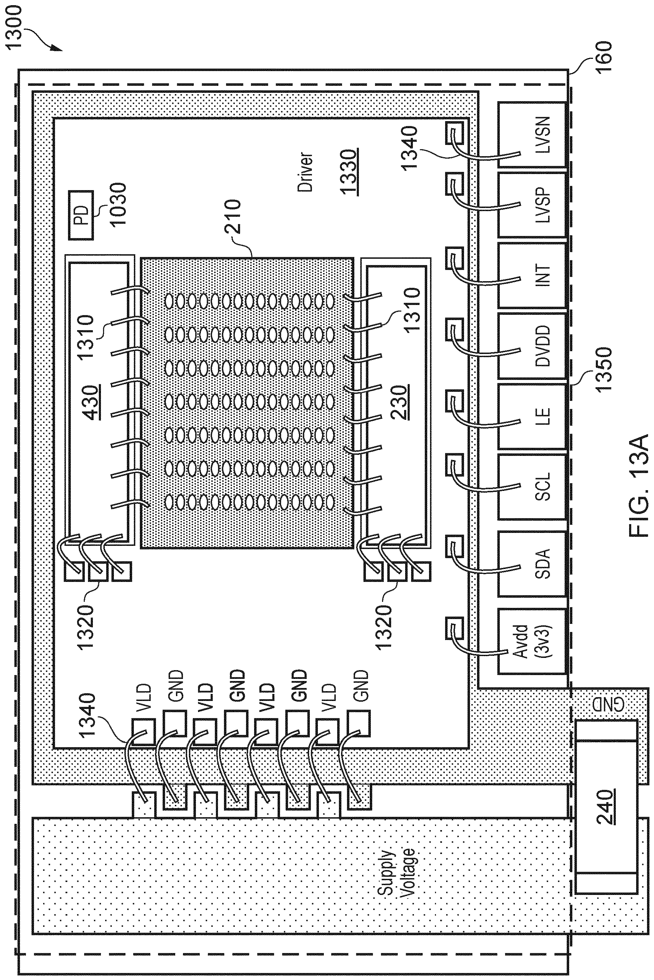

Figure 13A shows a further light source system 1300 in accordance with a configuration of the present disclosure. This system includes a module or package 1350 (represented with the dotted line) with a driver IC 1330 on the upper surface of which the VCSEL 210, the first capacitor 230 and the third capacitor 430 are directly mounted. The cathode of the VCSEL 210 may be die to die bonded to the driver 1330. The first capacitor 230 and the third capacitor 430 are vertical capacitors, of the type described earlier. The driver IC 1330 die may optionally be thinned so as to improve thermal dissipation. A number of terminals for coupling of the module or package 1350 to external components (for example SDA, SCL, etc) are represented. These are optional control for configuring, powering and controlling the driver and are not described further. The second capacitor 240 is external to the module or package 1350. A fourth capacitor 440 is not represented in this Figure, but it will be appreciated that the fourth capacitor 440 may optionally be included as part of the light source system 1300. Note that in this example the driver IC 1330 includes the photodiode 1030 embedded inside as previously discussed.

The driver IC 1330 may be conductively bonded to the reference voltage (ground (GND)) trace of the substrate/PCB on which it is mounted. Additionally, or alternatively, ground terminals of the driver IC 1330 may be coupled to terminals of the ground trace by interconnectors, such as the bond wires 1340. Supply voltage terminals of the driver IC 1330 may also be coupled to terminals of the supply voltage trace by interconnectors, such as bond wires 1340.

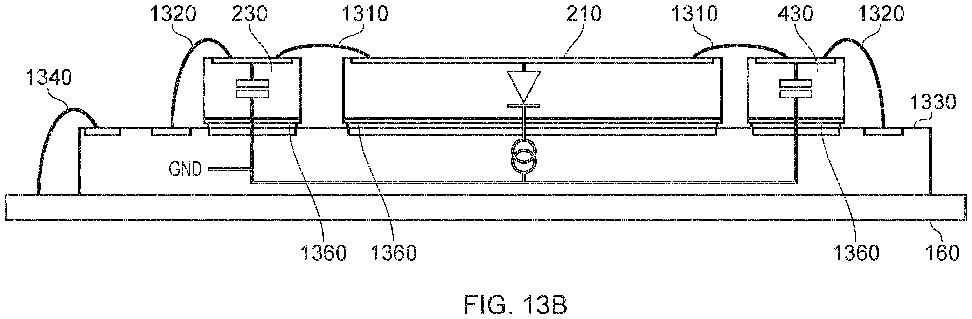

Figure 13B shows a side on view of part of the module or package 1350, so that the arrangement and interconnection of components may be more readily appreciated. As can be seen, the upper terminals of the first capacitor 230 and third capacitor 430 are each conductively coupled to the supply voltage by bond wires 1320. In this example, bond wires 1320 coupled the upper terminals of the capacitors to supply voltage terminals on the upper surface of the driver IC 1330. However, in an alternative arrangement interconnectors such as bond wires 1320 may directly couple the upper terminals of the capacitors to supply voltage terminals on the surface of the substrate/PCB on which the driver IC 1330 is mounted.

The upper terminals of the capacitors 230 and 430 are also electrically coupled to the upper terminal of the VCSEL 210 by interconnectors 1310, in this example bond wires. As can be seen, in this example the upper terminals of the capacitors 230 and 430 and the VCSEL are all at substantially the same height from the surface of the driver IC 1320, thereby minimising the length and "loop" of the bond wires 1310, and also enabling the capacitors to be positioned closer to the VCSEL 210.

The lower terminals of the capacitors 230 and 430 and the VCSEL 210 are all conductively bonded to terminals on the upper surface of the driver IC 1310 using conductive bonds 1360, in such a way that the lower terminal of the VCSEL 210 is coupled to the lower terminals of the capacitors 230 and 430 by the current driver (represented in Figure 13B by the current source symbol). In particular, the lower terminal of the VCSEL 210 may be conductively bonded to a first (current input) terminal of the current driver and the lower terminals of the first and third capacitors 230 and 430 coupled second (current output) terminals of the current driver, such that when the VCSEL is on current flows from the first terminal of the current driver, through the current driver to the second terminals of the current driver.

It will be appreciated from Figures 13A and 13B that the current loops formed by the first and third capacitors 230 and 430, the VCSEL 210 and the current driver are very compact. Furthermore, the current effectively travels in two planes - a first plane that includes the upper terminals of the capacitors 230 and 430 and the VCSEL 210, and a second plane that is the driver IC - with the current moving up and down between the planes through the capacitors 230 and 430, and through the VCSEL 210. Consequently, inductance of the circuit may be minimised, thereby enabling very fast initial turn on speeds using current stored in the capacitors 230 and 430. Furthermore, the physical size of the module or package 1350 is made very small, which made make it easier to use in the light source system 1300.

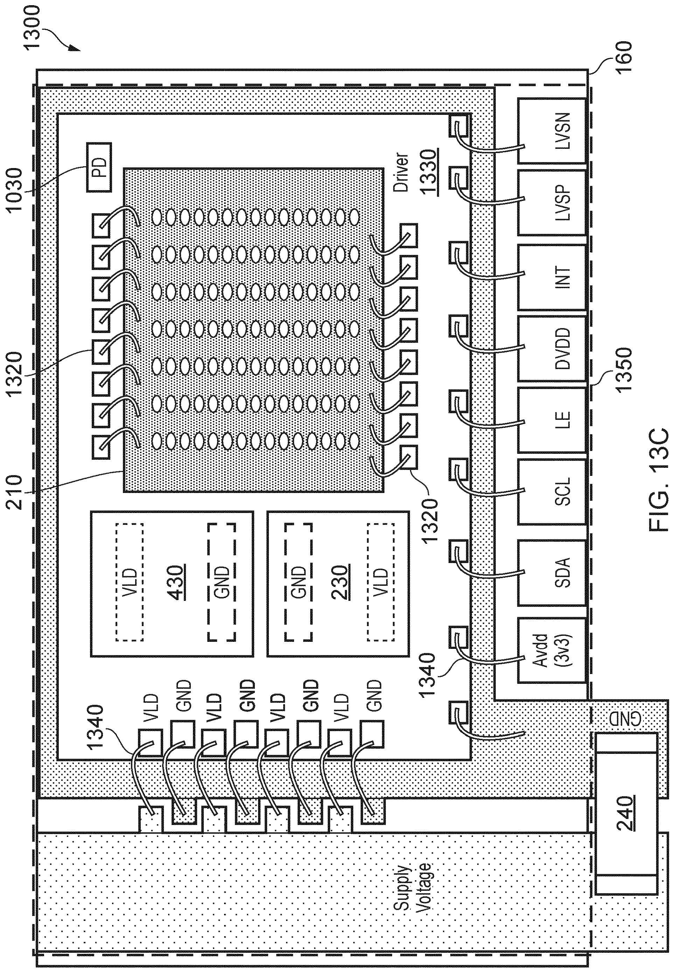

Figure 13C shows a further alternative implementation of the light source system 1300 that is very similar to that represented in Figure 13A, except the first and third capacitors 230 and 430 are lateral silicon design capacitors.

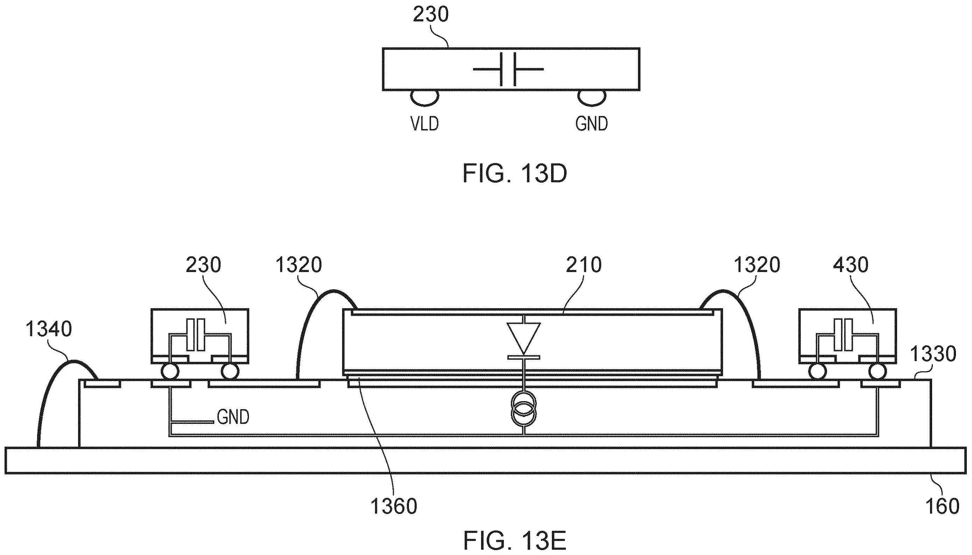

Figure 13D shows a side on representation of a lateral silicon design capacitor, which shows two bump terminal connections for the two plates of the capacitor. The two bump terminal connections may be conductively bonded by semiconductor processing to suitable conductive paths in the driver IC circuitry.

Figure 13E shows a side-on representation of the implementation represented in Figure 13C. As can be see, one of the terminals of each of the capacitors 230 and 430 is conductively bonded to a reference voltage (in this case, ground) conductive path in the IC circuitry. The other terminal of each of the capacitors 230 and 430 is conductively bonded to a supply voltage conductive path in the IC circuitry, which is also coupled by interconnects 1320 (in this example, bond wires) to the upper terminal of the VCSEL 210.

Lateral silicon capacitors are relatively low inductance devices and coupling the first and third capacitors 230 and 430 to the current driver and VCSEL 210 by conductively bonding to terminal son the surface of the driver IC may minimise inductances in the current loop. Therefore, very fast initial turn on speeds for the VCSEL may be achieved using current stored in the first and third capacitors 230 and 430.

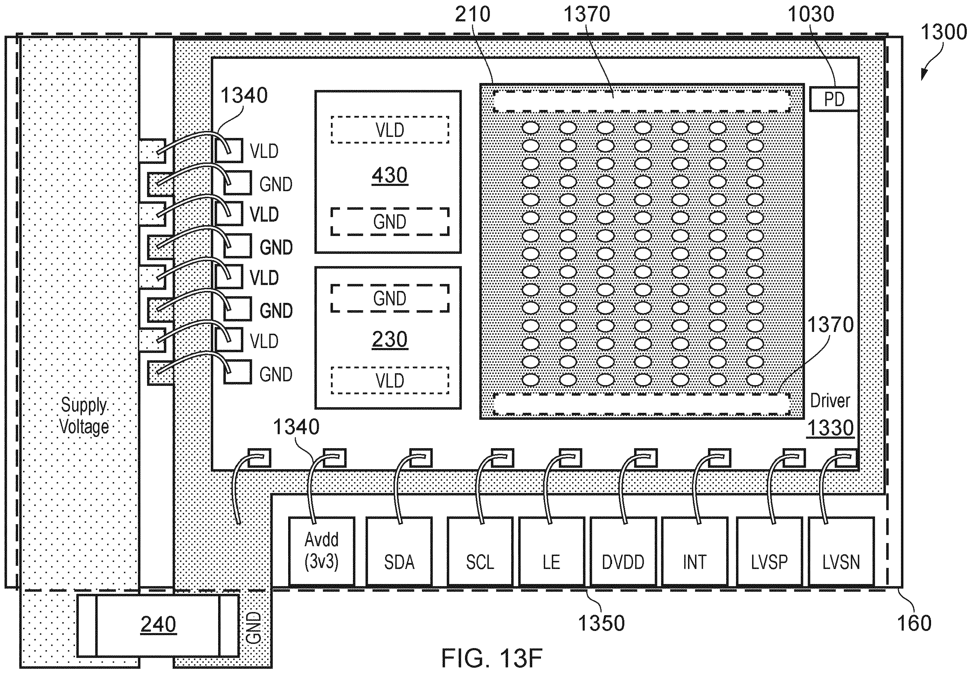

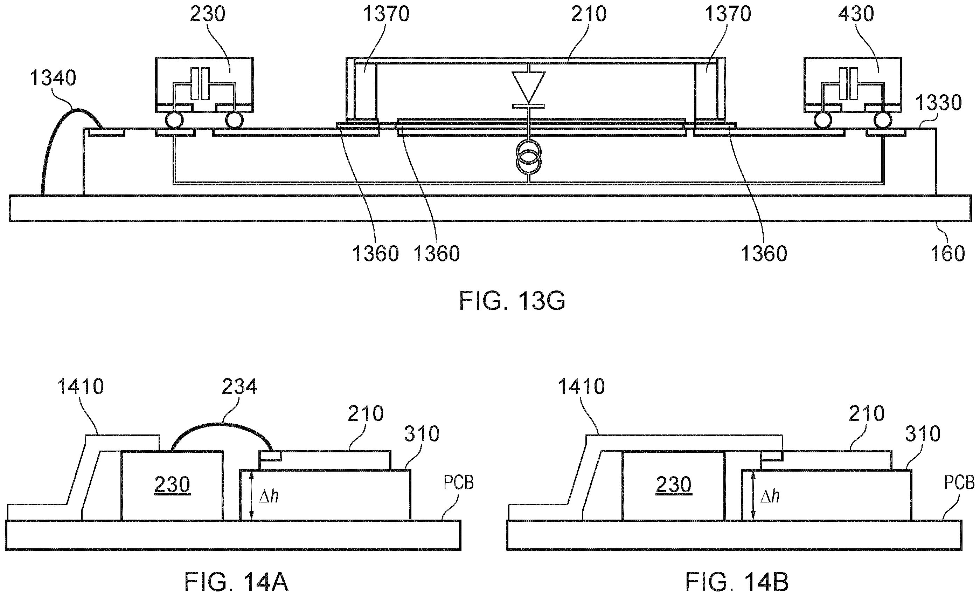

Figure 13F shows a further alternative implementation of the light source system 1300 that is very similar to that of Figure 13C, only both the anode and cathode terminals of the VCSEL 210 are on the mounting surface of the VCSEL 210. Figure 13G shows a side on view where this difference may be more readily appreciated.

In this alternative, the interconnections 1320 are not required and instead the VCSEL 1370 includes an internal via 1370 that routes current from its anode terminal on the mounting surface to the upper surface of the VCSEL 1370. The cathode and anode terminals of the VCSEL 210 may be conductively bonded to appropriate terminals on the surface of the driver IC by conductive bonding material 1360. Again, as with the implementation of Figures 13C to 13E, this arrangement may have a very low loop inductance, enabling very fast VCSEL 210 turn on speeds using current stored in the first and third capacitors 230 and 430.

In this approach the VCSEL 210 uses through silicon vias or the like to bring the anode terminal to the mounting surface of the VCSEL 210 in a different area to the cathode terminal, while the emitter apertures of the array of VCSEL emitters remain on the upper surface, allowing the light to emit from this surface. This is sometimes called back side illuminating or BSI.

It will be appreciated that some of the features represented in Figures 13A to 13G are optional. For example, in an alternative the PD 1030 may be omitted, the third capacitor 430 may be omitted and/or a fourth capacitor 440 may be used.

Optionally, the height of voltage supply and/or reference voltage (ground) terminals on the substrate 160 may effectively be raised to be substantially at the same height as the surface of the driver IC 1330. In this way, the bond wires 1340 may be made as short as possible with the minimum loop possible. Additionally or alternatively, in the implementations where there is an interconnect between the upper surface of the driver IC 1330 and the upper surface of the capacitors 230 and 430 (such as Figures 13A and 13B), or between the upper surface of the driver IC 1330 and the upper surface of the VCSEL 210 (such as Figures 13C and 13E), the height of the relevant driver IC terminals may be raised to be substantially the same as the height of the capacitors/VCSEL.. This may be achieved, for example, by growing a conductive layer (such as copper) on the die surface over the bonding terminals using any suitable semiconductor processing techniques. Alternatively, a conductive material (such as copper) may be affixed to the surface of the die over the bonding terminals using a suitable conductive epoxy. In both cases, a similar result to that represented in Figure 3C may be achieved, such that the length of the bond wires coupling the VCSEL 210 to the driver 1330 may be reduced and the amount of "loop" that they have also reduced, thereby further reducing inductance and resistance.

In all of the above disclosed systems, there are one or more capacitors arranged to form a relatively lower inductance loop with the VCSEL and driver, so as to supply the initial driver current with low parasitic inductance and therefore shorter rise time. One or more further capacitors are also coupled to the VCSEL and driver in a relatively higher inductance loop, so as to supply the peak current to the VCSEL, thereby achieving a relatively high peak driving current (although, as described earlier, the one or more further capacitors may be omitted and the peak current supplied only by the supply voltage). Consequently, a system that achieves both short rise and fall time, and high frequency operation may be realised, which may improve the accuracy and depth range of a ToF system using the light source system. Furthermore, the capacitor designs used for the capacitors delivering the initial current may be chosen to have very low parasitic inductance, even if their capacity/density is small. The capacitor designs used for the capacitors delivering the later current may be chosen to have high capacity/density in order to deliver a high peak current, even if their inductance is relatively high. Therefore, low inductance and high capacity benefits may be realised in the same system in order to deliver a short current rise time and high peak current.

In each of the examples described above, at least one coupling terminal of the first capacitor 230 (and optionally also third capacitor 430) may be substantially coplanar/at the same height with the terminals of the device to which it is coupled (for example, the VCSEL 210 or the driver). In some instances, this may be achieved by component selection, or by circuit design (such as that represented in Figure 13A). In other instances, one or more conductive platforms may be used to raise the height of the first capacitor 230 and/or the device to which it is coupled so that their respective terminals are substantially coplanar. Optionally, other surface couplings to the first capacitor 230 (and optionally also third capacitor 430) may be substantially coplanar/at the same height with the element to which the capacitor is being coupled. For example, if an upper surface of the capacitor is being wire bonded to the supply trace or ground trace of the mounting substrate, a platform may be used to raise the height of the trace bonding surface to be substantially coplanar with the upper surface of the capacitor.

Various example systems are disclosed above where the first capacitor 230 (and optionally third capacitor 430) is a vertical capacitor. In those examples, one of the capacitor plates (at the upper, or top, side of the capacitor) has two couplings, for example bond wires couplings or conductive clips. Typically, one of those couplings is to contact pad/trace on the substrate on which the capacitor is mounted, for example the supply voltage, and the other of those couplings is to a component of the laser drive circuit, such as the light source or the driver. The other capacitor plate (at the lower, or bottom, side of the capacitor) is typically conductively fixed to a contact pad/trace (such as ground) on the substrate on which the capacitor is mounted. By coupling the vertical capacitor within the laser drive circuit in this three coupling arrangement, loop inductance of the circuit may be reduced, thereby improving switch on speed. Similarly with the lateral interdigitated capacitor of Figure 9, bond wire coupling (or alternatively conductive clip coupling) is used to connect the two capacitor plates to three different elements/components. In particular one capacitor plate is wire bonded to the VCSEL and also wire bonded to the supply voltage trace on the substrate. The second capacitor plate is wire bonded to the ground trace on the substrate. Again, this three coupling arrangement may help to minimise loop impedance of the circuit.

In each of the examples above, the VCSEL, driver and first capacitor (and third capacitor) may be included in a single package/module such that the current loop formed by those components is small and has a small inductance. One or more (for example, two, three, four, etc) capacitors may be used for this fast rise time purpose. The second capacitor (and fourth capacitor) may be part of the package/module, or may be external to the package/module with the package/module being configured for the coupling of one or more external capacitors. One or more (for example, two, three, four, etc) capacitors may be used for this high peak current purpose. Furthermore, whilst each of the examples above include at least one relatively low capacity capacitor (eg, the first capacitor 230) and at least one relatively high capacity capacitor (eg, the second capacitor 240), in an alternative the circuit may have only one or more low capacity capacitor. In this case, the first capacitor 230 may supply an initial, first part of the drive current to turn the VCSEL 210 on quickly. The remainder of the drive current required in order to sustain the VCSEL in the on-state for the desired duration may be supplied by the voltage supply. Such an implementation may be particularly useful where the supply voltage is of a type that is capable of supplying the remainder of the required drive current, in which case circuit cost and physical size may be reduced by omitting the second capacitor 240. However, where the supply voltage is not suitable for supplying the entirety of the remainder of the required drive current, the second capacitor 240 may be included and the remainder of the required drive current supply by both the supply voltage and the second capacity 240.

Various aspects described herein include wire bonding. Wherever wire bonding is used, any other suitable form of surface electrical coupling may be used. For example, ribbon bonding and conductive clip coupling may alternatively be used. Figure 14A shows an example representation of a conductive clip 1410, such as a copper clip, being used to couple the first plate of the first capacitor 230 to a PCB trace, rather than using a wire bond. Figure 14B shows a further example of how the conductive clip may be extended so as also to couple the first plate of the first capacitor 230 to the VCSEL 210. In this example, it can be seen that even where wire bonds are not used, it may still be beneficial for the terminal connections between the first capacitor 230 and the VCSEL 210 to be in substantially the same plane (in this example achieved using the platform/podium 310) in order to reduce the current path length. The conductive clip may be fixed to the first capacitor 230 and/or the VCSEL 210 using any suitable material, for example a conductive epoxy.

Whilst the above light source systems are described particularly with reference to use with ToF camera systems, the light source system is not limited to this use and may be used for any other purpose. Furthermore, whilst each of the light source systems described above have a VCSEL as a light source, any suitable type of light source may alternatively be used, for example any other type of laser or LED.

Most of the examples given herein, the light source 210 has an anode terminal on its upper surface and a cathode terminal on its lower surface. However, with appropriate minor reconfigurations of the component connections in the rest of the circuit it may alternatively be the other way around. For example, in the arrangement of Figure 2A, the upper terminal of the first capacitor 230 may be coupled to the reference voltage (GND) trace by interconnects 232, rather than coupled to the supply voltage trace. The lower terminal may be conductively bonded to the supply voltage trace, along with a terminal of the driver 202, and another terminal of the driver 220 and the lower anode terminal of the light source 210 conductively bonded to an anode trace (essentially the same as the trace labelled "cathode" in Figure 2A). In this case, the driver 220 would be a high-side driver. To put it another way, the trace labelled "supply voltage" would become the reference voltage trace (ground), the trace labelled "GND" would become the supply voltage trace and the trace labelled "cathode" would become the anode trace. Likewise for the configuration of Figure 11A, the trace labelled "supply voltage" would become the reference voltage trace (ground), the trace labelled "GND" would become the supply voltage trace and the driver 1120 would become a low side driver.

The terms 'coupling' and 'coupled' are used throughout the present disclosure to encompass both direct electrical connections between two components/devices, and also indirect electrical coupling between two components/devices where there are one or more intermediate components/devices in the electrical coupling path between the two components/devices.

## Claims

1. A light source system (200) comprising:

   a substrate;
   a light source (210) mounted on a surface of the substrate, wherein the light source comprises:

      an upper surface of the light source having an upper terminal of the light source (210); and
      a mounting surface of the light source conductively fixed to the surface of the substrate and having a lower terminal of the light source (210), the light source (210) being configured to be driven by a drive current flowing between the upper terminal of the light source (210) and the lower terminal of the light source (210),

   a vertical capacitor (230) configured to supply a first part of the drive current to drive the light source (210), wherein the vertical capacitor (230) comprises:

      an upper surface of the vertical capacitor comprising an upper terminal of the vertical capacitor (230) to a first plate of the vertical capacitor, wherein the upper terminal of the vertical capacitor (230) is electrically coupled to the upper terminal of the light source (210); and
      a mounting surface of the vertical capacitor conductively fixed to the surface of the substrate and comprising a lower terminal of the vertical capacitor (230) to a second plate of the vertical capacitor (230); and

   a current driver (220) mounted on the surface of the substrate and coupled to the light source (210) and the vertical capacitor (230) for controlling a flow of the drive current from the vertical capacitor (230) to the light source in order to drive the light source (210),
   wherein the substrate comprises a voltage terminal that is electrically coupled to the vertical capacitor (230) and is configured to supply a second part of the drive current to drive the light source (210)

**characterized in that**

a distance between the surface of the substrate and the upper terminal of the light source (210) is substantially the same as a distance between the surface of the substrate and the upper terminal of the vertical capacitor (230).

2. The light source system (200) of claim 1, wherein the voltage terminal of the substrate is electrically coupled to the upper terminal of the vertical capacitor (230) by a first interconnector (232).

3. The light source system (200) of any preceding claim, wherein the light source (210) is mounted on the surface of the substrate using a conductive podium (310) having a thickness such that the distance between the surface of the substrate and the upper terminal of the light source (210) is substantially the same as the distance between the surface of the substrate and the upper terminal of the vertical capacitor (230).

4. The light source system (200) of any preceding claim, wherein the current driver (220) is a low-side driver and the lower terminal of the light source (210) is electrically coupled to the lower terminal of the vertical capacitor (230) by the current driver (220); and

   wherein the upper terminal of the vertical capacitor (230) is electrically coupled to the upper terminal of the light source (210) by a second interconnector (234), such that when the light source (210) is on the drive current flows from the upper terminal of the vertical capacitor (230) to the upper terminal of the light source (210) and then from the lower terminal of the light source (210 back to the vertical capacitor (230) via the current driver (220).

5. The light source system (200) of claim 4, wherein the substrate comprises:

   a first conductive path to which the lower terminal of the light source (210) and a first terminal of the current driver (220) are conductively fixed, such that when the light source is on the drive current flows through the first conductive path from the lower terminal of the light source (210) to the first terminal of the current driver (220); and
   a second conductive path to which the lower terminal of the vertical capacitor (230) and a second terminal of the current driver (220) are conductively fixed, such that when the light source is on the drive current flows through the second conductive path from the second terminal of the current driver to the lower terminal of the vertical capacitor.

6. The light source system (200) of claim 5, wherein the second conductive path is held at a reference potential.

7. The light source system (200) of any of claims 1 to 3, wherein the current driver (220) is a high-side driver and the upper terminal of the vertical capacitor (230) is electrically coupled to the upper terminal of the light source (210) by the current driver.

8. The light source system (200) of claim 7, wherein the substrate comprises a reference voltage conductive path to which the lower terminal of the light source (210) and the lower terminal of the vertical capacitor (230) are conductively fixed, such that when the light source (210) is on the drive current flows through a first conductive path from the lower terminal of the light source (210) to the lower terminal of the vertical capacitor (230).

9. The light source system (200) of claim 8, wherein a part of the reference voltage conductive path passes underneath the current driver (220) such that when the light source (210) is on the drive current flows through the reference voltage conductive path from the lower terminal of the light source (210) to the lower terminal of the vertical capacitor (230), underneath the current driver (220) in substantially an opposite direction to a drive current flow from the upper terminal of the vertical capacitor (230) to the upper terminal of the light source (210).

10. The light source system (200) of any of claims 7 to 9, wherein the current driver (220) comprises:

    a first surface having a third terminal and a fourth terminal; and
    a second surface that is fixed to the surface of the substrate,
    wherein the upper terminal of the vertical capacitor is coupled to the third terminal of the current driver by a third interconnector and the fourth terminal of the current driver is coupled to the upper terminal of the light source by a fourth interconnector.

11. The light source system (200) of claim 10, wherein the upper terminal of the light source, the upper terminal of the vertical capacitor (230) and the third and fourth terminals of the current driver (210) are all at substantially the same distance from the surface of the substrate.

12. The light source system (200) of any preceding claim, wherein the first interconnector comprises:

    a conductive platform having a mounting surface that is conductively fixed to the voltage terminal and an upper surface that is at substantially the same distance from the surface of the substrate as the upper terminal of the vertical capacitor; and

at least one conductive element fixed to the upper surface of the conductive platform and the upper terminal of the vertical capacitor (230).

13. The light source system (200) of any preceding claim, further comprising a further capacitor (240) for supplying a third part of the drive current to drive the light source,

wherein the further capacitor (240) has a larger capacitance than the vertical capacitor (230), and

wherein the vertical capacitor (230), light source (210) and current driver (220) are coupled together to form a first current loop, and

wherein the further capacitor (240), light source (210) and current driver (220) are coupled together to form a second current loop.

14. The light source system (200) of any preceding claim, further comprising a further vertical capacitor (430), wherein the further vertical capacitor (430) comprises:

an upper surface of the further vertical capacitor comprising an upper terminal of the further vertical capacitor to a first plate of the further vertical capacitor (430), wherein the upper terminal of the further vertical capacitor (430) is electrically coupled to a further upper terminal of the light source (210), wherein the upper terminal of the light source (210) is positioned at a first side of the upper surface of the light source (210) and the further upper terminal of the light source (210) is positioned at a second, opposing side of the upper surface of the light source (210); and

a mounting surface of the further vertical capacitor conductively fixed to the surface of the substrate and comprising a lower terminal of the further vertical capacitor to a second plate of the further vertical capacitor, wherein the further vertical capacitor (430) is electrically coupled to the voltage terminal of the substrate and is positioned on an opposite side of the light source (210) to a position of the first vertical capacitor (230) such that when the light source (210) is on the drive current flows from the vertical capacitor (230) to the light source (210) in substantially an opposite direction to the drive current that flows from the further vertical capacitor (430) to the light source (410).

**Patentansprüche**

1. Ein Lichtquellensystem (200), umfassend:

ein Substrat;
eine Lichtquelle (210), die auf einer Oberfläche des Substrats montiert ist, wobei die Lichtquelle umfasst:

eine obere Oberfläche der Lichtquelle, die einen oberen Anschluss der Lichtquelle (210) umfasst, und
eine Montagefläche der Lichtquelle, die leitend an der Oberfläche des Substrats befestigt ist, umfassend

einen unteren Anschluss der Lichtquelle (210), wobei die Lichtquelle (210) dazu eingerichtet ist, um durch einen Ansteuerungsstrom betrieben zu werden, der zwischen dem oberen Anschluss der Lichtquelle (210) und dem unteren Anschluss der Lichtquelle (210) fließt,
einen vertikalen Kondensator (230), der dazu eingerichtet ist, um einen ersten Teil des Ansteuerungsstroms zu liefern, um die Lichtquelle (210) zu betreiben, wobei der vertikale Kondensator (230) umfasst:

eine obere Oberfläche des vertikalen Kondensators, die einen oberen Anschluss des vertikalen Kondensators (230) zu einer ersten Platte des vertikalen Kondensators umfasst, wobei der obere Anschluss des vertikalen Kondensators (230) elektrisch mit dem oberen Anschluss der Lichtquelle (210) gekoppelt ist, und
eine Montagefläche des vertikalen Kondensators, die leitend an der Oberfläche des Substrats befestigt ist und einen unteren Anschluss des vertikalen Kondensators (230) zu einer zweiten Platte des vertikalen Kondensators (230) umfasst, und

einen Stromtreiber (220), der auf der Oberfläche des Substrats montiert ist und mit der Lichtquelle (210) und dem vertikalen Kondensator (230) gekoppelt ist, um einen Stromfluss des Ansteuerungsstroms vom vertikalen Kondensator (230) zur Lichtquelle zu steuern, um die Lichtquelle (210) zu betreiben,
wobei das Substrat einen Spannungsanschluss umfasst, der elektrisch mit dem vertikalen Kondensator (230) gekoppelt ist und dazu eingerichtet ist, um einen zweiten Teil des Ansteuerungsstroms zu liefern, um die Lichtquelle (210) zu betreiben,
**dadurch gekennzeichnet, dass** ein Abstand zwischen der Oberfläche des Substrats und dem oberen Anschluss der Lichtquelle (210) im Wesentlichen gleich dem Abstand zwischen der Oberfläche des Substrats und dem oberen Anschluss des vertikalen Kondensators (230) ist.

2. Das Lichtquellensystem (200) nach Anspruch 1, wobei der Spannungsanschluss des Substrats elektrisch über einen ersten Verbinder (232) mit dem oberen Anschluss des vertikalen Kondensators (230) gekoppelt ist.

3. Das Lichtquellensystem (200) nach einem der vorhergehenden Ansprüche, wobei die Lichtquelle (210) auf der Oberfläche des Substrats unter Verwendung eines leitfähigen Podests (310) mit einer derartigen Dicke montiert ist, dass der Abstand zwischen der Oberfläche des Substrats und dem oberen Anschluss der Lichtquelle (210) im Wesentlichen gleich dem Abstand zwischen der Oberfläche des Substrats und dem oberen Anschluss des vertikalen Kondensators (230) ist.

4. Das Lichtquellensystem (200) nach einem der vorhergehenden Ansprüche, wobei der Stromtreiber (220) ein Low-Side-Treiber ist und der untere Anschluss der Lichtquelle (210) elektrisch mit dem unteren Anschluss des vertikalen Kondensators (230) durch den Stromtreiber (220) gekoppelt ist, und wobei der obere Anschluss des vertikalen Kondensators (230) elektrisch mit dem oberen Anschluss der Lichtquelle (210) über einen zweiten Verbinder (234) gekoppelt ist, sodass, wenn die Lichtquelle (210) eingeschaltet ist, der Ansteuerungsstrom vom oberen Anschluss des vertikalen Kondensators (230) zum oberen Anschluss der Lichtquelle (210) und dann vom unteren Anschluss der Lichtquelle (210) zurück zum vertikalen Kondensator (230) über den Stromtreiber (220) fließt.

5. Das Lichtquellensystem (200) nach Anspruch 4, wobei das Substrat umfasst:

einen ersten leitenden Pfad, an den der untere Anschluss der Lichtquelle (210) und ein erster Anschluss des Stromtreibers (220) leitend befestigt sind, sodass, wenn die Lichtquelle eingeschaltet ist, der Ansteuerungsstrom durch den ersten leitenden Pfad vom unteren Anschluss der Lichtquelle (210) zum ersten Anschluss des Stromtreibers (220) fließt, und einen zweiten leitenden Pfad, an den der untere Anschluss des vertikalen Kondensators (230) und ein zweiter Anschluss des Stromtreibers (220) leitend befestigt sind, sodass, wenn die Lichtquelle eingeschaltet ist, der Ansteuerungsstrom durch den zweiten leitenden Pfad vom zweiten Anschluss des Stromtreibers zum unteren Anschluss des vertikalen Kondensators fließt.

6. Das Lichtquellensystem (200) nach Anspruch 5, wobei der zweite leitende Pfad auf einem Referenzpotenzial gehalten wird.

7. Das Lichtquellensystem (200) nach einem der Ansprüche 1 bis 3, wobei der Stromtreiber (220) ein High-Side-Treiber ist und der obere Anschluss des vertikalen Kondensators (230) elektrisch mit dem oberen Anschluss der Lichtquelle (210) durch den Stromtreiber gekoppelt ist.

8. Das Lichtquellensystem (200) nach Anspruch 7, wobei das Substrat einen Referenzspannungspfad umfasst, an den der untere Anschluss der Lichtquelle (210) und der untere Anschluss des vertikalen Kondensators (230) leitend befestigt sind, sodass, wenn die Lichtquelle (210) eingeschaltet ist, der Ansteuerungsstrom durch einen ersten leitenden Pfad vom unteren Anschluss der Lichtquelle (210) zum unteren Anschluss des vertikalen Kondensators (230) fließt.

9. Das Lichtquellensystem (200) nach Anspruch 8, wobei ein Teil des Referenzspannungspfads unterhalb des Stromtreibers (220) verläuft, sodass, wenn die Lichtquelle (210) eingeschaltet ist, der Ansteuerungsstrom durch den Referenzspannungspfad vom unteren Anschluss der Lichtquelle (210) zum unteren Anschluss des vertikalen Kondensators (230) unterhalb des Stromtreibers (220) in im Wesentlichen entgegengesetzter Richtung zu einem Ansteuerungsstromfluss vom oberen Anschluss des vertikalen Kondensators (230) zum oberen Anschluss der Lichtquelle (210) fließt.

10. Das Lichtquellensystem (200) nach einem der Ansprüche 7 bis 9, wobei der Stromtreiber (220) umfasst:

eine erste Oberfläche mit einem dritten Anschluss und einem vierten Anschluss; und eine zweite Oberfläche, die an der Oberfläche des Substrats befestigt ist, wobei der obere Anschluss des vertikalen Kondensators mit dem dritten Anschluss des Stromtreibers durch einen dritten Verbinder gekoppelt ist und der vierte Anschluss des Stromtreibers mit dem oberen Anschluss der Lichtquelle durch einen vierten Verbinder gekoppelt ist.

11. Das Lichtquellensystem (200) nach Anspruch 10, wobei der obere Anschluss der Lichtquelle, der obere Anschluss des vertikalen Kondensators (230) und der dritte und vierte Anschluss des Stromtreibers (210) alle in im Wesentlichen gleichem Abstand von der Oberfläche des Substrats angeordnet sind.

12. Das Lichtquellensystem (200) nach einem der vorhergehenden Ansprüche, wobei der erste Verbinder umfasst:

eine leitende Plattform mit einer Montagefläche, die leitend an den Spannungsanschluss befestigt ist, und einer oberen Oberfläche, die in im Wesentlichen gleichem Abstand von der Oberfläche des Substrats wie der obere Anschluss des vertikalen Kondensators ist, und mindestens ein leitfähiges Element, das an der oberen Oberfläche der leitenden Plattform und am oberen Anschluss des vertikalen Kondensators (230) befestigt ist.

13. Das Lichtquellensystem (200) nach einem der vorhergehenden Ansprüche, ferner umfassend einen weiteren Kondensator (240) zum Bereitstellen eines dritten Teils des Ansteuerungsstroms zum Steuern der Lichtquelle,

wobei der weitere Kondensator (240) eine größere Kapazität als der vertikale Kondensator (230) aufweist, und
wobei der vertikale Kondensator (230), die Lichtquelle (210) und der Stromtreiber (220) miteinander gekoppelt sind, um eine erste Stromschleife zu bilden; und
wobei der weitere Kondensator (240), die Lichtquelle (210) und der Stromtreiber (220) miteinander gekoppelt sind, um eine zweite Stromschleife zu bilden.

14. Das Lichtquellensystem (200) nach einem der vorhergehenden Ansprüche, ferner umfassend einen weiteren vertikalen Kondensator (430), wobei der weitere vertikale Kondensator (430) umfasst:

eine obere Oberfläche des weiteren vertikalen Kondensators, die einen oberen Anschluss des weiteren vertikalen Kondensators zu einer ersten Platte des weiteren vertikalen Kondensators (430) umfasst, wobei der obere Anschluss des weiteren vertikalen Kondensators (430) elektrisch mit einem weiteren oberen Anschluss der Lichtquelle (210) verbunden ist,
wobei der obere Anschluss der Lichtquelle (210) auf einer ersten Seite der oberen Oberfläche der Lichtquelle (210) angeordnet ist und der weitere obere Anschluss der Lichtquelle (210) auf einer gegenüberliegenden zweiten Seite der oberen Oberfläche der Lichtquelle (210) angeordnet ist, und
eine Montagefläche des weiteren vertikalen Kondensators, die leitend an der Oberfläche des Substrats befestigt ist und einen unteren Anschluss des weiteren vertikalen Kondensators zu einer zweiten Platte des weiteren vertikalen Kondensators umfasst,
wobei der weitere vertikale Kondensator (430) elektrisch mit dem Spannungsanschluss des Substrats gekoppelt ist und auf einer gegenüberliegenden Seite der Lichtquelle (210) angeordnet ist, verglichen mit einer Position des ersten vertikalen Kondensators (230), sodass, wenn die Lichtquelle (210) eingeschaltet ist, der Ansteuerungsstrom vom vertikalen Kondensator (230) zur Lichtquelle (210) in im Wesentlichen entgegengesetzter Richtung zu dem Ansteuerungsstrom fließt, der vom weiteren vertikalen Kondensator (430) zur Lichtquelle (210) fließt.

## Revendications

1. Système de source de lumière (200), comprenant :

un substrat ;
une source de lumière (210) montée sur une surface du substrat, dans lequel la source de lumière comprend :

une surface supérieure de la source de lumière présentant une borne supérieure de la source de lumière (210) ; et
une surface de montage de la source de lumière fixée de manière conductrice à la surface du substrat et présentant

une borne inférieure de la source de lumière (210), la source de lumière (210) étant configurée pour être commandée par un courant d'entraînement circulant entre la borne supérieure de la source de lumière (210) et la borne inférieure de la source de lumière (210),
un condensateur vertical (230) configuré pour fournir une première partie du courant d'entraînement pour entraîner la source de lumière (210), dans lequel le condensateur vertical (230) comprend :

une surface supérieure du condensateur vertical comprenant une borne supérieure du condensateur vertical (230) à une première plaque du condensateur vertical, dans lequel la borne supérieure du condensateur vertical (230) est couplée électriquement à la borne supérieure de la source de lumière (210) ; et
une surface de montage du condensateur vertical fixée de manière conductrice à la surface du substrat et comprenant une borne inférieure du condensateur vertical (230) à une seconde plaque du condensateur vertical (230) ; et

un pilote de courant (220) monté sur la surface du substrat et couplé à la source de lumière (210) et au condensateur vertical (230) pour commander un écoulement du courant d'entraînement du condensateur vertical (230) à la source de lumière afin d'entraîner la source de lumière (210),
dans lequel le substrat comprend une borne de tension qui est couplée électriquement au condensateur vertical (230) et est configurée pour fournir une seconde partie du courant d'entraînement afin d'entraîner la source de lumière (210)
**caractérisé en ce que**
une distance entre la surface du substrat et la borne supérieure de la source de lumière (210) est sensiblement la même qu'une distance entre la surface du substrat et la borne supérieure du condensateur vertical (230).

2. Système de source de lumière (200) selon la revendication 1, dans lequel la borne de tension du substrat est couplée électriquement à la borne supérieure du condensateur vertical (230) par un premier interconnecteur (232).

3. Système de source de lumière (200) selon l'une quelconque des revendications précédentes, dans lequel la source de lumière (210) est montée sur la surface du substrat en utilisant un podium conducteur (310) présentant une épaisseur telle que la distance entre la surface du substrat et la borne supérieure de la source de lumière (210) est sensiblement la même que la distance entre la surface du substrat et la borne supérieure du condensateur vertical (230).

4. Système de source de lumière (200) selon l'une quelconque des revendications précédentes, dans lequel le pilote de courant (220) est un pilote côté bas et la borne inférieure de la source de lumière (210) est couplée électriquement à la borne inférieure du condensateur vertical (230) par le pilote de courant (220) ; et
dans lequel la borne supérieure du condensateur vertical (230) est couplée électriquement à la borne supérieure de la source de lumière (210) par un deuxième interconnecteur (234), de telle sorte que lorsque la source de lumière (210) est en marche, le courant d'entraînement circule de la borne supérieure du condensateur vertical (230) à la borne supérieure de la source de lumière (210), puis de la borne inférieure de la source de lumière (210 en retour vers le condensateur vertical (230) via le pilote de courant (220).

5. Système de source de lumière (200) selon la revendication 4, dans lequel le substrat comprend :

un premier trajet conducteur auquel la borne inférieure de la source de lumière (210) et une première borne du pilote de courant (220) sont fixées de manière conductrice, de sorte que lorsque la source de lumière est en marche, le courant d'entraînement circule à travers le premier trajet conducteur depuis la borne inférieure de la source de lumière (210)vers la première borne du pilote de courant (220) ; et
un second trajet conducteur auquel la borne inférieure du condensateur vertical (230) et une deuxième borne du pilote de courant (220) sont fixées de manière conductrice, de telle sorte que lorsque la source de lumière est en marche, le courant d'entraînement s'écoule à travers le second trajet conducteur depuis la deuxième borne du pilote de courant vers la borne inférieure du condensateur vertical.

6. Système de source de lumière (200) selon la revendication 5, dans lequel le second trajet conducteur est maintenu à un potentiel de référence.

7. Système de source de lumière (200) selon l'une quelconque des revendications 1 à 3, dans lequel le pilote de courant (220) est un pilote de courant côté haut et la borne supérieure du condensateur vertical (230) est couplée électriquement à la borne supérieure de la source de lumière (210) par le pilote de courant.

8. Système de source de lumière (200) selon la revendication 7, dans lequel le substrat comprend un trajet conducteur de tension de référence auquel la borne inférieure de la source de lumière (210) et la borne inférieure du condensateur vertical (230) sont fixées de manière conductrice, de telle sorte que lorsque la source de lumière (210) est en marche, le courant d'entraînement circule à travers un premier trajet conducteur de la borne inférieure de la source de lumière (210) à la borne inférieure du condensateur vertical (230).

9. Système de source de lumière (200) selon la revendication 8, dans lequel une partie du trajet conducteur de tension de référence passe sous le pilote de courant (220) de telle sorte que lorsque la source de lumière (210) est en marche, le courant d'entraînement circule à travers le trajet conducteur de tension de référence de la borne inférieure de la source de lumière (210) à la borne inférieure du condensateur vertical (230), sous le pilote de courant (220) dans une direction sensiblement opposée à un écoulement de courant d'entraînement de la borne supérieure du condensateur vertical (230) à la borne supérieure de la source de lumière (210).

10. Système de source de lumière (200) selon l'une quelconque des revendications 7 à 9, dans lequel le pilote de courant (220) comprend :

une première surface présentant une troisième borne et une quatrième borne ; et
une seconde surface qui est fixée à la surface du substrat,
dans lequel la borne supérieure du condensateur vertical est couplée à la troisième borne du pilote de courant par un troisième interconnecteur et la quatrième borne du pilote de courant est couplée à la borne supérieure de la source de lumière par un quatrième interconnecteur.

11. Système de source de lumière (200) selon la revendication 10, dans lequel la borne supérieure de la source de lumière, la borne supérieure du condensateur vertical (230) et les troisième et quatrième bornes du courant d'entraînement (210) sont toutes sensiblement à la même distance de la surface du substrat.

12. Système de source de lumière (200) selon l'une quelconque des revendications précédentes, dans lequel le premier interconnecteur comprend :

une plate-forme conductrice présentant une surface de montage qui est fixée de manière conductrice à la borne de tension et une surface supérieure qui est sensiblement à la même distance de la surface du substrat que la borne supérieure du condensateur vertical ; et
au moins un élément conducteur fixé à la surface supérieure de la plate-forme conductrice et à la borne supérieure du condensateur vertical (230).

13. Système de source de lumière (200) selon l'une quelconque des revendications précédentes, comprenant en outre un condensateur supplémentaire (240) pour fournir une troisième partie du courant d'entraînement pour entraîner la source de lumière, dans lequel le condensateur supplémentaire (240) présente une capacité plus grande que le condensateur vertical (230), et

dans lequel le condensateur vertical (230), la source de lumière (210) et le pilote de courant (220) sont couplés ensemble pour former une première boucle de courant, et
dans lequel le condensateur supplémentaire (240), la source de lumière (210) et le pilote de courant (220) sont couplés ensemble pour former une seconde boucle de courant.

14. Système de source de lumière (200) selon l'une quelconque des revendications précédentes, comprenant en outre un condensateur vertical supplémentaire (430), dans lequel le condensateur vertical supplémentaire (430) comprend :

une surface supérieure du condensateur vertical supplémentaire comprenant une borne supérieure du condensateur vertical supplémentaire à une première plaque du condensateur vertical supplémentaire (430), dans lequel la borne supérieure du condensateur vertical supplémentaire (430) est couplée électriquement à une borne supérieure supplémentaire de la source de lumière (210), dans lequel la borne supérieure de la source de lumière (210) est positionnée au niveau d'un premier côté de la surface supérieure de la source de lumière (210) et la borne supérieure supplémentaire de la source de lumière (210) est positionnée au niveau d'un second côté opposé de la surface supérieure de la source de lumière (210) ; et
une surface de montage du condensateur vertical supplémentaire fixée de manière conductrice à la surface du substrat et comprenant une borne inférieure du condensateur vertical supplémentaire à une seconde plaque du condensateur vertical supplémentaire,
dans lequel le condensateur vertical supplémentaire (430) est couplé électriquement à la borne de tension du substrat et est positionné sur un côté opposé de la source de lumière (210) à une position du premier condensateur vertical (230) de telle sorte que lorsque la source de lumière (210) est en marche, le courant d'entraînement s'écoule du condensateur vertical (230) à la source de lumière (210) dans sensiblement une direction opposée au courant d'entraînement qui s'écoule du condensateur vertical supplémentaire (430) à la source de lumière (410).

Top view

Anode

Cathode

110

Conductive
Heatsink

120

142

130

140

FIG. 1A

Side view

142

Diffuser

120

130

140

FIG. 1B

FIG. 1C

FIG. 1D

EP 3 943 976 B1

FIG. 1E

FIG. 2A

FIG. 2B

FIG. 3A

FIG. 3B

FIG. 3C

FIG. 3D

FIG. 4A

FIG. 4B

FIG. 5A

FIG. 5B

FIG. 6

EP 3 943 976 B1

FIG. 7A

FIG. 7B

EP 3 943 976 B1

FIG. 8A

FIG. 8B

FIG. 9

FIG. 10A

EP 3 943 976 B1

FIG. 10B

FIG. 10C

FIG. 11A

EP 3 943 976 B1

FIG. 11B

FIG. 12

EP 3 943 976 B1

FIG. 13A

EP 3 943 976 B1

FIG. 13B

EP 3 943 976 B1

FIG. 13C

EP 3 943 976 B1

FIG. 13D

FIG. 13E

FIG. 13F

**FIG. 13G**

**FIG. 14A**

**FIG. 14B**

EP 3 943 976 B1

**EP 3 943 976 B1**

**Patent documents cited in the description**

- US 20180278011 A1